# EUROPEAN PATENT APPLICATION

(11) **EP 3 901 214 A1**
(43) Date of publication of application: **27.10.2021**
(21) Application number: 19898553.3
(22) Date of filing: 18.12.2019
(51) Int. Cl.: C08L 63/00, C08K 3/013, C08K 3/22, C08K 3/36, C08K 5/54, C08L 39/04

(54) **THERMOSETTING RESIN COMPOSITION FOR LDS AND METHOD FOR PRODUCING SEMICONDUCTOR DEVICE**

(30) Priority: 18.12.2018 JP 2018236604; 15.02.2019 JP 2019025899; 15.02.2019 JP 2019025900
(71) Applicant: Sumitomo Bakelite Co.Ltd., Shinagawa-ku Tokyo 140-0002 (JP)
(72) Inventor: KODA, Masaya, Tokyo 140-0002 (JP); ENDO, Masashi, Tokyo 140-0002 (JP)
(74) Representative: Müller-Boré & Partner Patentanwälte PartG mbB
(86) International application number: PCT/JP2019/049527
(87) International publication number: WO 2020/130012

(57) **Abstract**

A thermosetting resin composition for laser direct structuring (LDS) which is used for LDS includes the following components: (A) a thermosetting resin; (B) an inorganic filler; (C) a non-conductive metal compound that forms a metal nucleus upon irradiation with active energy rays; and (D) a coupling agent, in which the component (A) contains one or more selected from the group consisting of an epoxy resin and a bismaleimide resin, and at least one of the following conditions is satisfied.
Condition 1: a ratio of particles having a particle size equal to or more than 1 µm and equal to or less than 20 µm in the component (B) is equal to or more than 40% by volume and equal to or less than 95% by volume with respect to a total volume of the component (B), and
Condition 2: an angle of fall of the thermosetting resin composition for LDS is equal to or less than 35°.

## Description

### TECHNICAL FIELD

The present invention relates to a thermosetting resin composition for LDS, and a method for manufacturing a semiconductor device.

### BACKGROUND ART

As a technique relating to a resin material used for laser direct structuring (LDS), there are techniques disclosed in Patent Documents 1 to 3.

Patent Document 1 (Japanese Laid-Open Patent Publication No. 2015-134903) discloses a fiber-reinforced resin material obtained by impregnating a thermoplastic resin composition containing an LDS additive with continuous fibers, in which a polyamide resin is used as the thermoplastic resin.

Patent Document 2 (Japanese Laid-Open Patent Publication No. 2015-163682) discloses a polymer composition which is obtained by incorporating a specific amount of each of a glass filler and a metal oxide into a crystalline cyclic olefin ring-opening polymer hydrogenated product having a repeating unit derived from a polycyclic norbornene-based monomer having equal to or more than three rings, and by which favorable electrical characteristics (low dielectric loss tangent), plating adhesion, and reflow heat resistance are realized.

In addition, Patent Document 3 (Published Japanese Translation No. 2017-513794 of the PCT International Publication) discloses a core-shell composite material produced with specific components as a technique relating to inorganic encapsulating of metal oxides, mixed metal oxides, and metal compounds which are potentially used as additives to impart a color, flame retardance, process modification, smoke reduction, antibacterial characteristics, laser marking, or "activation" which relate to a process of laser direct structuring, and many additional functions proved in the technical field.

### RELATED DOCUMENT

### PATENT DOCUMENT

[Patent Document 1] Japanese Laid-Open Patent Publication No. 2015-134903
[Patent Document 2] Japanese Laid-Open Patent Publication No. 2015-163682
[Patent Document 3] Published Japanese Translation No. 2017-513794 of the PCT International Publication

### SUMMARY OF THE INVENTION

### TECHNICAL PROBLEM

However, when the inventor of the present invention examined a resin composition applied to LDS, it became clear that there is room for improvement in terms of plating deposit characteristics in fine processing by LDS, and miniaturization during circuit formation.

In addition, the inventors of the present invention examined use of fine processing by LDS in manufacturing of semiconductor devices such as molded interconnect devices (MID).

Accordingly, the present invention provides a technique that has excellent plating deposit characteristics in the fine processing by LDS, and enables reduction in interconnect width and interconnect interval when forming a circuit.

### SOLUTION TO PROBLEM

According to the present invention,
there is provided a thermosetting resin composition for laser direct structuring (LDS) which is used for LDS, the thermosetting resin composition for LDS including the following components:
   (A) a thermosetting resin;
   (B) an inorganic filler;
   (C) a non-conductive metal compound that forms a metal nucleus upon irradiation with active energy rays; and
   (D) a coupling agent,
in which the component (A) contains one or more selected from the group consisting of an epoxy resin and a bismaleimide resin, and
at least one of the following condition 1 or condition 2 is satisfied.
   (Condition 1) A ratio of particles having a particle size equal to or more than 1 µm and equal to or less than 20 µm in the component (B) is equal to or more than 40% by volume and equal to or less than 95% by volume with respect to a total volume of the component (B).
   (Condition 2) The thermosetting resin composition for LDS is granular, and an angle of fall of the thermosetting resin composition for LDS is equal to or less than 35°.

According to the present invention,
there is provided a method for manufacturing a semiconductor device, the method including:
encapsulating a semiconductor element, such that a surface of the semiconductor element is covered, with a cured product of a thermosetting resin composition for laser direct structuring (LDS) to form an encapsulating material;
irradiating a specific portion on a surface of the encapsulating material with active energy rays;
hydrophilizing the surface of the encapsulating material; and
selectively forming a metal layer in a region, which is irradiated with the active energy rays, on the surface of the encapsulating material,
in which the thermosetting resin composition for LDS is the thermosetting resin composition for LDS of the present invention.

According to the present invention,
there is provided a method for manufacturing a semiconductor device, the method including:
encapsulating a semiconductor element, such that a surface of the semiconductor element is covered, with a cured product of a thermosetting resin composition for laser direct structuring (LDS) to form an encapsulating material;
irradiating a specific portion on a surface of the encapsulating material with active energy rays;
hydrophilizing the surface of the encapsulating material; and
selectively forming a metal layer in a region, which is irradiated with the active energy rays, on the surface of the encapsulating material,
in which the thermosetting resin composition for LDS contains:
   (A) a thermosetting resin,
   (B) an inorganic filler,
   (C) a non-conductive metal compound that forms a metal nucleus upon irradiation with active energy rays, and
   (D) a coupling agent, and
the component (A) contains one or more selected from the group consisting of an epoxy resin and a bismaleimide resin.

Any combination of these configurations, and the conversion of the expression of the present invention between methods, devices, and the like are also effective as aspects of the present invention.

For example, according to the present invention, a resin molded article including a cured product of the thermosetting resin composition for LDS of the present invention is provided.

Furthermore, according to the present invention,
there is provided a three-dimensional molded interconnect device including:
the resin molded article of the present invention having a three-dimensional structure; and
a three-dimensional circuit formed on a surface of the resin molded article.

Furthermore, according to the present invention, it is also possible to provide a semiconductor device obtained by the method for manufacturing a semiconductor device of the present invention.

### ADVANTAGEOUS EFFECTS OF INVENTION

According to the present invention, it is possible to provide a technique that has excellent plating deposit characteristics in the fine processing by LDS, and enables reduction in interconnect width and interconnect interval when forming a circuit.

### BRIEF DESCRIPTION OF THE DRAWINGS

[Fig. 1] Cross-sectional views each showing a manufacturing step for a semiconductor device in an embodiment.
[Fig. 2] A cross-sectional view showing a configuration of a semiconductor device according to an embodiment.
[Fig. 3] A schematic view showing a method of measuring an angle of fall (θ) and an angle of repose (φ).

### DESCRIPTION OF EMBODIMENTS

Hereinafter, embodiments of the present invention will be described with reference to the drawings. In all the drawings, same components are designated by the same reference numerals, and description thereof will not be repeated as appropriate. Furthermore, the drawings are schematic views, and dimensional ratios thereof do not necessarily match actual dimensional ratios. In addition, the embodiments of the present invention will be described below with reference to specific examples of each of components. In the present embodiment, a composition may contain one kind of each of the components alone or may contain two or more kinds thereof in combination. Furthermore, hereinafter, configurations of the respective embodiments may be combined as appropriate.

### (First embodiment)

When the inventor of the present invention examined a resin composition applied to LDS, it became clear that there is room for improvement in terms of plating deposit characteristics in the fine processing by LDS, and miniaturization during circuit formation.

The present embodiment provides a resin composition which has excellent moldability and excellent plating deposit characteristics when being fine processed by LDS, and enables reduction in interconnect width and interconnect interval when forming a circuit.

According to the present embodiment,
there is provided a thermosetting resin composition for laser direct structuring (LDS) which is used for LDS, the thermosetting resin composition for LDS including the following components:
   (A) a thermosetting resin;
   (B) an inorganic filler;
   (C) a non-conductive metal compound that forms a metal nucleus upon irradiation with active energy rays; and
   (D) a coupling agent, and
in which the component (A) contains one or more selected from the group consisting of an epoxy resin and a bismaleimide resin, and
a ratio of particles having a particle size equal to or more than 1 µm and equal to or less than 20 µm in the component (B) is equal to or more than 40% by volume and equal to or less than 95% by volume with respect to a total volume of the component (B).

Any combination of these configurations, and the conversion of the expression of the present embodiment between methods, devices, and the like are also effective as aspects of the present embodiment.

For example, according to the present embodiment, there is provided a resin molded article including a cured product of the thermosetting resin composition for LDS of the present embodiment.

Furthermore, according to the present embodiment,
there is provided a three-dimensional molded interconnect device including:
the resin molded article of the present invention having a three-dimensional structure; and
a three-dimensional circuit formed on a surface of the resin molded article.

According to the present embodiment, it is possible to provide a resin composition which has excellent moldability and excellent plating deposit characteristics when being fine processed by LDS, and enables reduction in interconnect width and interconnect interval when forming a circuit.

In the present embodiment, the thermosetting resin composition is a thermosetting resin composition for laser direct structuring (LDS) which is used for LDS. LDS is one of methods for manufacturing a three-dimensional molded interconnect device (MID). In LDS, specifically, a surface of a resin molded article containing an LDS additive is irradiated with active energy rays to generate a metal nucleus, and using the metal nucleus as a seed, a plated pattern is formed in a region irradiated with the energy rays by a plating treatment such as electroless plating. Conductive members such as interconnects and circuits can be formed based on this plated pattern.

In the present embodiment, the thermosetting resin composition for LDS (hereinafter, also simply referred to as a "thermosetting resin composition") contains the following components (A) to (D).
(A) A thermosetting resin;
(B) An inorganic filler;
(C) A non-conductive metal compound that forms a metal nucleus upon irradiation with active energy rays; and
(D) A coupling agent

In addition, the component (A) contains one or more selected from the group consisting of an epoxy resin and a bismaleimide resin, and a ratio of particles having a particle size equal to or more than 1 µm and equal to or less than 20 µm in the component (B) is equal to or more than 40% by volume and equal to or less than 95% by volume with respect to a total volume of the component (B).

In the present embodiment, by appropriately selecting the type of the component (A) and a size of the component (B) in the thermosetting resin composition, it is possible to obtain a thermosetting resin composition having excellent moldability, and a cured product of the thermosetting resin composition which has excellent plating deposit characteristics when being fine processed by LDS, and it is also possible to reduce an interconnect width and an interconnect interval when forming a circuit.

Hereinafter, the respective components of the thermosetting resin composition of the present embodiment will be described.

### (Component (A))

The component (A) is a thermosetting resin. The component (A) contains one or more selected from the group consisting of an epoxy resin and a bismaleimide resin, from the viewpoint of improving plating deposit characteristics in the fine processing by LDS by using the component (A) in combination with the component (B) having a specific size, and reducing an interconnect width and an interconnect interval when forming a circuit.

Furthermore, the component (A) preferably contains an epoxy resin, and it is more preferably an epoxy resin, from the viewpoint of improving curability, preservability, heat resistance, moisture resistance, and chemical resistance.

Meanwhile, the component (A) preferably contains a bismaleimide resin, and it is more preferably a bismaleimide resin, from the viewpoint of obtaining more excellent heat resistance.

As an epoxy resin, an entirety of monomers, oligomers, or polymers having two or more epoxy groups within one molecule can be used, and their molecular weights or molecular structures are not limited.

The epoxy resin includes, for example, one or two or more selected from the group consisting of biphenyl-type epoxy resins; bisphenol-type epoxy resins such as a bisphenol A-type epoxy resin, a bisphenol F-type epoxy resin, and a tetramethylbisphenol F-type epoxy resin; stilbene-type epoxy resins; novolac-type epoxy resins such as a phenol novolac-type epoxy resin and a cresol novolac-type epoxy resin; polyfunctional epoxy resins such as trisphenol-type epoxy resins exemplified as a triphenolmethane-type epoxy resin, an alkyl-modified triphenolmethane-type epoxy resin, or the like; phenol aralkyl-type epoxy resins such as a phenol aralkyl-type epoxy resin having a phenylene skeleton, a naphtholaralkyl-type epoxy resin having a phenylene skeleton, a phenol aralkyl-type epoxy resin having a biphenylene skeleton, and a naphtholaralkyl-type epoxy resin having a biphenylene skeleton; naphthol-type epoxy resins such as a dihydroxynaphthalene-type epoxy resin and an epoxy resin obtainable by glycidyl-etherification of a dimer of dihydroxynaphthalene; triazine nucleus-containing epoxy resins such as triglycidyl isocyanurate and monoallyl diglycidyl isocyanurate; and bridged cyclic hydrocarbon compound-modified phenol-type epoxy resins such as a dicyclopentadiene-modified phenol-type epoxy resin.

From the viewpoint of reducing a warp of a molded product obtainable by curing the thermosetting resin composition or improving a balance of all the characteristics such as fillability, heat resistance, and moisture resistance, among those, the novolac-type epoxy resins, the polyfunctional epoxy resins, or the phenol aralkyl-type epoxy resins can be preferably used. Furthermore, from the same viewpoint, the epoxy resin preferably includes one or more selected from the group consisting of an orthocresol novolac-type epoxy resin, a phenol aralkyl-type epoxy resin having a biphenylene skeleton, and a triphenylmethane-type epoxy resin, and more preferably includes one or more selected from the group consisting of an orthocresol novolac-type epoxy resin and a phenol aralkyl-type epoxy resin having a biphenylene skeleton.

In addition, the bismaleimide resin is a (co)polymer of a compound having two or more maleimide groups.

The compound having two or more maleimide groups includes, for example, at least one of a compound represented by General Formula (1) and a compound represented by General Formula (2). Accordingly, a glass transition temperature of a cured product of the thermosetting resin composition can be increased, and heat resistance of the cured product can be improved more effectively.

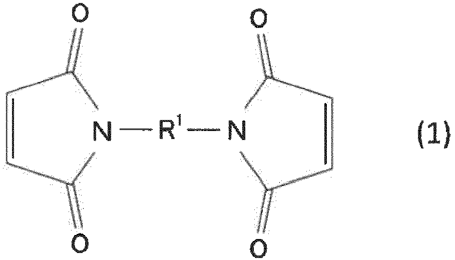

In General Formula (1), R¹ is a divalent organic group having 1 or more and 30 or less carbon atoms, and may contain one or more of an oxygen atom and a nitrogen atom. From the viewpoint of improving heat resistance of a cured product, R¹ is more preferably an organic group containing an aromatic ring. In the present embodiment, as R¹, for example, a structure such as General Formula (1a) or (1b) can be exemplified.

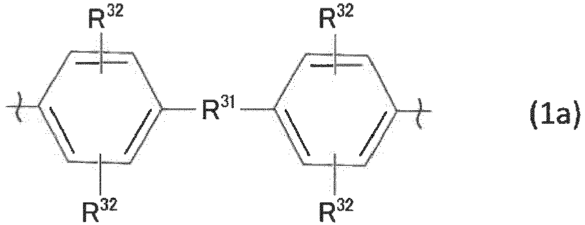

In General Formula (1a), R³¹ is a divalent organic group which has 1 or more and 18 or less carbon atoms and may contain one or more of an oxygen atom and a nitrogen atom. Furthermore, a plurality of R³²'s are each independently a hydrogen atom or a substituted or unsubstituted hydrocarbon group having 1 or more and 4 or less carbon atoms.

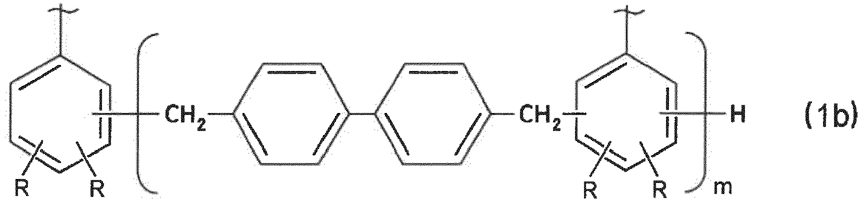

In General Formula (1b), a plurality of R's are each independently present. R represents a hydrogen atom, an alkyl group having 1 to 5 carbon atoms, or a phenyl group, and R is preferably a hydrogen atom. Furthermore, m is an average value, which is a number of 1 or more and 5 or less, is preferably a number larger than 1 and 5 or less, is more preferably a number larger than 1 and 3 or less, and is even more preferably a number larger than 1 and 2 or less.

Examples of the compound represented by General Formula (1) that can be applied in the present embodiment include compounds represented by Formulas (1-1) to (1-3).

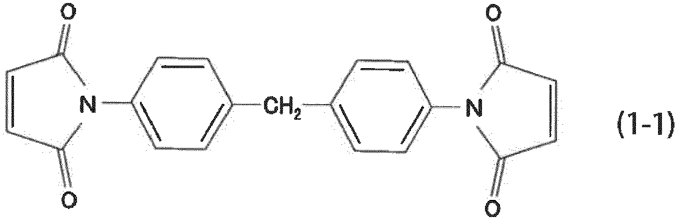

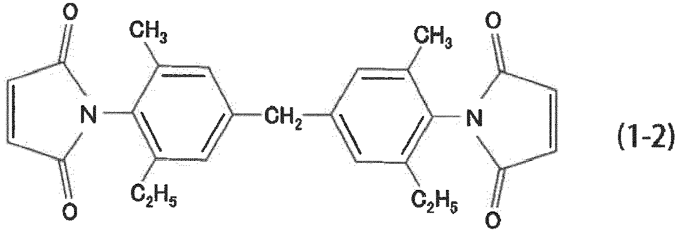

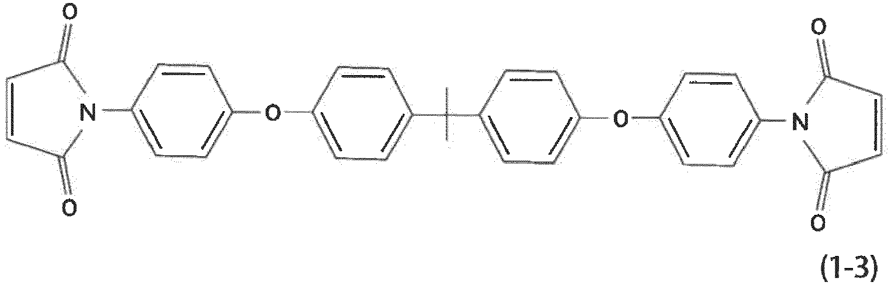

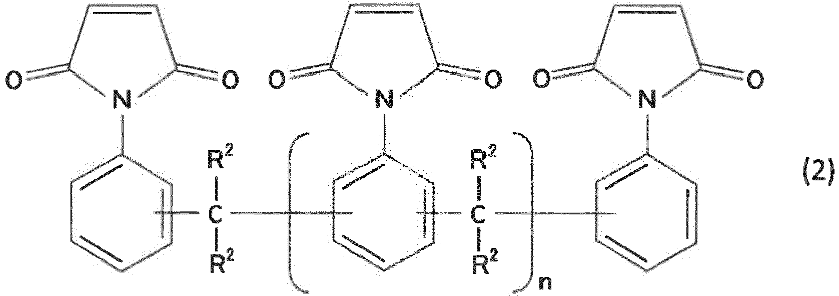

In General Formula (2), a plurality of R²'s are each independently a hydrogen atom or a substituted or unsubstituted hydrocarbon group having 1 or more and 4 or less carbon atoms. n is an average value, which is a number of 0 or more and 10 or less, and is preferably 0 or more and 5 or less.

Furthermore, the component (A) may further contain another thermosetting resin. Examples of such thermosetting resins include one or two or more selected from the group consisting of unsaturated polyester resins such as a benzoxazine resin, a phenol resin, a urea (urea) resin, and a melamine resin, a polyurethane resin, a diallyl phthalate resin, a silicone resin, a cyanate resin, a polyimide resin, a polyamideimide resin, and a benzocyclobutene resin.

Furthermore, the component (A) may contain a resin curing agent such as a phenol resin curing agent to be described later.

A content of the component (A) in the thermosetting resin composition is preferably equal to or more than 1% by mass, is more preferably equal to or more than 2% by mass, and is even more preferably equal to or more than 2.5% by mass, with respect to a total mass of the thermosetting resin composition, from the viewpoint of improving fluidity when molding and improving fillability and molding stability.

Meanwhile, a content of the component (A) is preferably equal to or less than 15% by mass, is more preferably equal to or less than 14% by mass, and is even more preferably equal to or less than 13% by mass, with respect to a total mass of the thermosetting resin composition, from the viewpoint of improving moisture resistance reliability and reflow resistance and reducing warp of a molded product.

In the present embodiment, a content with respect to a total amount of the thermosetting resin composition refers to a content with respect to the total solid content resulting from the removal of a solvent in the thermosetting resin composition in a case where the thermosetting resin composition includes the solvent. The solid content of the thermosetting resin composition refers to non-volatile components in the thermosetting resin composition, and refers to a residue resulting from the removal of volatile components such as water and solvents.

### (Component (B))

The component (B) is an inorganic filler. Examples of inorganic fillers include one or two or more materials selected from the group consisting of molten silica such as molten crushed silica and molten spherical silica; silica such as crystalline silica and amorphous silica; silicon dioxide; alumina; aluminum hydroxide; silicon nitride; and aluminum nitride. The component (B) preferably includes silica such as molten crushed silica, molten spherical silica, and crystalline silica, and it is more preferably silica, from the viewpoint that then, mechanical properties or thermal properties of a cured product of the thermosetting resin composition are preferable.

A ratio of particles having a particle size equal to or more than 1 µm and equal to or less than 20 µm in the component (B) is equal to or more than 40% by volume and is more preferably equal to or more than 70% by volume with respect to a total volume of the component (B), from the viewpoint of improving plating deposit characteristics in the fine processing by LDS, and reducing an interconnect width and an interconnect interval (line and space) when forming a circuit.

A ratio of particles having a particle size equal to or more than 1 µm and equal to or less than 20 µm in the component (B) is equal to or less than 95% by volume from the viewpoint of improving moldability.

A particle size D₁₀ of the component (B) is, for example, equal to or more than 0.03 µm, is preferably equal to or more than 0.05 µm, is more preferably equal to or more than 0.1 µm, and is even more preferably equal to or more than 0.3 µm, from the viewpoint of improving moldability.

Meanwhile, a particle size d₁₀ of the component (B) is preferably equal to or less than 3 µm, is more preferably equal to or less than 2.0 µm, is even more preferably equal to or less than 1.0 µm, and is still more preferably equal to or less than 0.8 µm, from the viewpoint of reducing a plated interconnect width after laser processing.

A particle size d₅₀ of the component (B) is preferably equal to or more than 1.0 µm and is more preferably equal to or more than 2.0 µm from the viewpoint of improving moldability.

**Meanwhile, a particle size d₅₀ of the component (B) is** preferably equal to or less than 10 µm, is more preferably equal to or less than 7.0 µm, and is even more preferably equal to or less than 5.0 µm, from the viewpoint of reducing a plated **interconnect width after laser processing.**

**A maximum diameter dₘₐₓ of the component (B) is preferably** equal to or more than 5.0 µm, is more preferably equal to or more than 6.5 µm, and is even more preferably equal to or more than 8.0 µm, from the viewpoint of improving moldability.

**Meanwhile, a maximum diameter dₘₐₓ of the component (B) is** preferably equal to or less than 80 µm, is more preferably equal to or less than 60 µm, and is even more preferable equal to or less than 40 µm, from the viewpoint of reducing **an interconnect width and an interconnect interval (line and space) when forming a circuit. From the same viewpoint, a maximum diameter dₘₐₓ of** the component (B) is preferably equal to or less than 15 µm, is more preferably equal to or less than 12 µm, and is even more **preferably equal** to or less than 10 µm.

**A particle size distribution of the inorganic filler can be measured based on a particle size distribution of particles in terms of a volume using a commercially available laser diffraction particle size distribution analyzer (for example, SALD-7000 manufactured by Shimadzu Corporation).**

**A content of the component (B) in the thermosetting resin** composition is preferably equal to or more than 65% by mass, is more preferably equal to or more than 70% by mass, and is even more preferably equal to or more than 75% by mass, with respect to a total mass of the thermosetting resin composition, from the viewpoint of improving heat resistance and moisture resistance of a cured product.

Meanwhile, a content of the component (B) is preferably equal to or less than 95% by mass, is more preferably equal to or less than 90% by mass, and is even more preferably equal to or less than 85% by mass, with respect to a total mass of the thermosetting resin composition, from the viewpoint of more effectively improving fluidity and fillability of the thermosetting resin composition when molding.

### (Component (C))

The component (C) is a non-conductive metal compound that forms a metal nucleus upon irradiation with active energy rays. Such a compound acts as an LDS additive. The component (C) is not limited as long as it can form a metal nucleus upon irradiation with active energy rays. Detailed mechanism thereof is not clear, but it is considered that such the non-conductive metal compound allows the metal nucleus to be activated (for example, reduced), and thus, a metal nucleus capable of being plated with a metal upon irradiation with active energy rays such as YAG laser having an absorbable wavelength region is produced. Incidentally, in a case where a surface of a cured product of a thermosetting resin composition having the non-conductive metal compound dispersed therein is irradiated with the active energy rays, a seed region having a metal nucleus capable of being plated with a metal is formed on the irradiated surface. By using the obtained seed region, it is possible to form a plated pattern such as a circuit on a surface of the cured product of the thermosetting resin composition.

The component (C) includes, for example, one or more selected from the group consisting of (i) spinel-type metal oxide, (ii) metal oxide having two or more transition metal elements in groups adjacent to each other, the groups being selected from groups 3 to 12 of the periodic table, and (iii) tin-containing oxide.

In (i), the spinel-type structure is one of representative crystal structure types that are double oxides and found in AB₂O₄-type compounds (A and B are metal elements). The spinel structure may be any one of a forward spinel structure (A and B are partially interchanged) and an inverse spinel structure (B(AB)O₄), but the forward spinel structure can be more preferably used. In this case, A in the forward spinel structure may be copper.

As a metal atom constituting the spinel-type metal oxide, for example, copper or chromium can be used. That is, the component (C) can contain a spinel-type metal oxide including copper or chromium. For example, from the viewpoint of increasing adhesiveness to a copper-plated pattern, copper can be used as the metal atom.

Moreover, as the metal atom, in addition to copper or chromium, metal atoms such as antimony, tin, lead, indium, iron, cobalt, nickel, zinc, cadmium, silver, bismuth, arsenic, manganese, magnesium, and calcium may be contained in trace amounts. These metal atoms in trace amounts may exist in the form of an oxide. Further, the contents of those metal atoms in trace amounts can be each equal to or less than 0.001% by mass with respect to all the metal atoms in the metal oxides.

The spinel-type metal oxide is thermally highly stable, and can have durability in an acidic or alkaline aqueous metallization bath. The spinel-type metal oxide can be present in a high oxidation state in a non-irradiated region on a surface of a cured product of the thermosetting resin composition, for example, by appropriately controlling the dispersibility of the thermosetting resin composition. Examples of such the spinel-type metal oxide include those described in, for example, Published Japanese Translation No. 2004-534408 of the PCT International Publication.

(ii) Metal oxide having the transition metal elements is a metal oxide having two or more transition metal elements in groups adjacent to each other, the groups being selected from groups 3 to 12 of the periodic table. The metal belonging to the transition metal element can be represented to contain metals belonging to a group n and metals in a group n+1 of the periodic table. As the metal oxide having the transition metal elements, oxides of the metals may be used singly or in combination of two or more kinds thereof.

Examples of the metals belonging to a group n of the periodic table include a group 3 (scandium and yttrium), a group 4 (titanium, zirconium, and the like), a group 5 (vanadium, niobium, and the like), a group 6 (chromium, molybdenum, and the like), a group 7 (manganese and the like), a group 8 (iron, ruthenium, and the like), a group 9 (cobalt, rhodium, iridium, and the like), a group 10 (nickel, palladium, and platinum), a group 11 (copper, silver, gold, and the like), a group 12 (zinc, cadmium, and the like), and a group 13 (aluminum, gallium, indium, and the like).

Examples of the metals in a group n+1 of the periodic table include a group 4 (titanium, zirconium, and the like), a group 5 (vanadium, niobium, and the like), a group 6 (chromium, molybdenum, and the like), a group 7 (manganese and the like), a group 8 (iron, ruthenium, and the like), a group 9 (cobalt, rhodium, iridium, and the like), a group 10 (nickel, palladium, and platinum), a group 11 (copper, silver, gold, and the like), a group 12 (zinc, cadmium, and the like), and a group 13 (aluminum, gallium, indium, and the like).

Examples of such the metal oxide having the transition metal elements include those described in, for example, Published Japanese Translation No. 2004-534408 of the PCT International Publication.

Furthermore, (iii) tin-containing oxide is a metal oxide containing at least tin. A metal atom constituting the tin-containing oxide may contain antimony, in addition to tin. Such the tin-containing oxide may contain tin oxide or antimony oxide. More specifically, in the metal components included in the tin-containing oxide, tin accounts for equal to or more than 90% by mass and antimony may account for equal to or more than 5% by mass. This tin-containing oxide may further contain lead and/or copper as the metal component. Specifically, in the metal components included in the tin-containing oxide, for example, tin can account for equal to or more than 90% by mass, antimony can account for 5% to 9% by mass, lead can account for a range of 0.01% to 0.1% by mass, and copper can account for a range of 0.001% to 0.01% by mass. Such the tin-containing oxide can contain, for example, one or more of tin oxide and antimony oxide, and lead oxide and copper oxide. Further, the tin-containing oxide may contain metal atoms in trace amounts, exemplified as the spinel-type metal oxide.

In addition, the tin-containing oxide may also be used in combination with (i) the spinel-type metal oxide or (ii) metal oxide having the transition metal elements.

A content of the component (C) in the thermosetting resin composition is, for example, equal to or more than 2% by mass, is preferably equal to or more than 4% by mass, and is more preferably equal to or more than 8% by mass, with respect to a total mass of the thermosetting resin composition, from the viewpoint that then, plating deposit characteristics of a cured product of the thermosetting resin composition is favorable. Furthermore, a content of the component (C) is, for example, equal to or less than 20% by mass, is preferably equal to or less than 18% by mass, and is more preferably equal to or less than 15% by mass, with respect to a total mass of the thermosetting resin composition, from the viewpoint of reducing a decrease in insulating properties and an increase in anti in a cured product of the thermosetting resin composition, and from the viewpoint that then, fluidity of the thermosetting resin composition is favorable in a case where a shape of the component (C) is non-spherical.

Furthermore, a total content of the component (B) and the component (C) in the thermosetting resin composition is preferably equal to or more than 70% by mass and is more preferably equal to or more than 75% by mass with respect to a total mass of the thermosetting resin composition from the viewpoint of improving resin mechanical properties and resin strength.

Meanwhile, a total content of the component (B) and the component (C) is preferably equal to or less than 98% by mass and is more preferably equal to or less than 95% by mass with respect to a total mass of the thermosetting resin composition from the viewpoint of improving moldability.

### (Component (D))

The component (D) is a coupling agent. The component (D) preferably includes one or more selected from the group consisting of mercaptosilane, aminosilane, and epoxysilane, from the viewpoint that then, a viscosity of the thermosetting resin composition is optimized, and thereby mold formality is improved. From the viewpoint of continuous mold formality, mercaptosilane is preferable, from the viewpoint of fluidity, secondary aminosilane is preferable, and from the viewpoint of adhesiveness, epoxysilane is preferable.

Among them, examples of the epoxysilanes include γ-glycidoxypropyltriethoxysilane, γ-glycidoxypropyltrimethoxysilane, γ-glycidoxypropylmethyldimethoxysilane, and β-(3, 4-epoxycyclohexyl)ethyltrimethoxysilane, where γ-glycidoxypropylmethyldimethoxysilane is preferable.

Examples of the aminosilane include phenylaminopropyltrimethoxysilane, γ-aminopropyltriethoxysilane, γ-aminopropyltrimethoxysilane, N-β-(aminoethyl)-γ-aminopropyltrimethoxysilane, N-β-(aminoethyl)-γ-aminopropylmethyldimethoxysilane, N-phenyl-γ-aminopropyltriethoxysilane, N-phenyl-γ-aminopropyltrimethoxysilane, N-β-(aminoethyl)-γ-aminopropyltriethoxysilane, N-6-(aminohexyl)-3-aminopropyltrimethoxysilane, and N-(3-(trimethoxysilylpropyl)-1,3-benzenedimethanane, where N-Phenyl-γ-aminopropyltriethoxysilane is preferable. A latent aminosilane coupling agent protected by reacting a primary amino moiety of aminosilane with ketone or aldehyde may be used. In addition, a secondary amino group may be contained in the aminosilane.

In addition, examples of the mercaptosilane include a silane coupling agent exhibiting the same function as the mercaptosilane coupling agent by thermal decomposition, such as bis(3-triethoxysilylpropyl)tetrasulfide and bis(3-triethoxysilylpropyl)disulfide, in addition to γ-mercaptopropyltrimethoxysilane and 3-mercaptopropylmethyldimethoxysilane, where γ-mercaptopropyltrimethoxysilane is preferable.

In addition, these silane coupling agents may also be added after hydrolyzing in advance. These silane coupling agents may be used singly or in a combination of two or more kinds thereof.

A content of the component (D) in the thermosetting resin composition is preferably equal to or more than 0.01% by mass, is more preferably equal to or more than 0.05% by mass, and is even more preferably equal to or more than 0.1% by mass, with respect to a total mass of the thermosetting resin composition, from the viewpoint that then, a flow length of the thermosetting resin composition is increased, and thereby injection moldability is improved.

Meanwhile, a content of the component (D) is preferably equal to or less than 1% by mass, is more preferably equal to or less than 0.8% by mass, and is even more preferably equal to or less than 0.6% by mass, with respect to a total mass of the thermosetting resin composition, from the viewpoint that then, an increase in water-absorbing properties of a cured product of the thermosetting resin composition is reduced, and thereby favorable anti-rust properties are obtained.

### (Other components)

In the present embodiment, the thermosetting resin composition may contain components other than the above-described components (A) to (D).

For example, the thermosetting resin composition may further contain (E) a curing accelerator.

### (Component (E))

The component (E) is a curing accelerator. The curing accelerator may be any of curing accelerators which accelerate a crosslinking reaction between a thermosetting resin and a curing agent, and curing accelerators that are used for general thermosetting resin compositions can be used.

Examples of the component (E) include one or two or more selected from phosphorus atom-containing compounds such as an organic phosphine, a tetra-substituted phosphonium compound, a phosphobetaine compound, an adduct of a phosphine compound and a quinone compound, and an adduct of a phosphonium compound and a silane compound; and nitrogen atom-containing compounds such as amidines or tertiary amines such as 1,8-diazabicyclo[5.4.0]undecene-7, benzyldimethylamine, and 2-methylimidazole, and quaternary salts of the amidines or the amines. Among these, the phosphorus atom-containing compounds are preferably included from the viewpoint of improving the curability. In addition, from the viewpoint of improving a balance between moldability and curability, it is more preferable to include those having latency, such as a tetra-substituted phosphonium compound, a phosphobetaine compound, an adduct of a phosphine compound and a quinone compound, and an adduct of a phosphonium compound and a silane compound. From the same viewpoint, the component (E) preferably includes one or more selected from tetraphenylphosphonium bis(naphthalene-2,3-dioxy)phenylsilicate and tetraphenylphosphonium-4,4'-sulfonyldiphenolate.

Examples of the organic phosphine include primary phosphines such as ethylphosphine and phenylphosphine; secondary phosphines such as dimethylphosphine and diphenylphosphine; and tertiary phosphines such as trimethylphosphine, triethylphosphine, tributylphosphine, and triphenylphosphine.

Examples of the tetra-substituted phosphonium compound include a compound represented by General Formula (6).

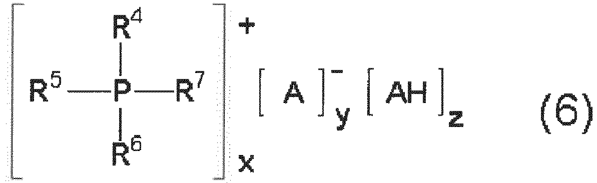

(In General Formula (6), P represents a phosphorus atom; R⁴, R⁵, R⁶, and R⁷ each represent an aromatic group or an alkyl group; A represents an anion of an aromatic organic acid having at least one functional group selected from a hydroxyl group, a carboxyl group, and a thiol group in an aromatic ring; AH represents an aromatic organic acid having at least one functional group selected from a hydroxyl group, a carboxyl group, and a thiol group in an aromatic ring; and x and y are each a number of 1 to 3, and z is a number of 0 to 3, with x = y.)

The compound represented by General Formula (6) can be obtained, for example, as follows, but the method is not limited thereto. First, a tetra-substituted phosphonium halide, an aromatic organic acid, and a base are added to an organic solvent and uniformly mixed to produce an aromatic organic acid anion in the solution system. Subsequently, water is added to the solution, and thus, the compound represented by General Formula (6) can be precipitated. In the compound represented by General Formula (6), R⁴, R⁵, R⁶, and R⁷, all of which are bonded to a phosphorus atom, are each preferably a phenyl group, AH is preferably a compound in which a hydroxyl group is bonded to an aromatic ring, that is, phenols, and A is preferably an anion of the phenols. Examples of the phenols include monocyclic phenols such as phenol, cresol, resorcin, and catechol, fused polycyclic phenols such as naphthol, dihydroxynaphthalene, and anthraquinol, bisphenols such as bisphenol A, bisphenol F, and bisphenol S, and polycyclic phenols such as phenylphenol and biphenol.

Examples of the phosphobetaine compound include a compound represented by General Formula (7).

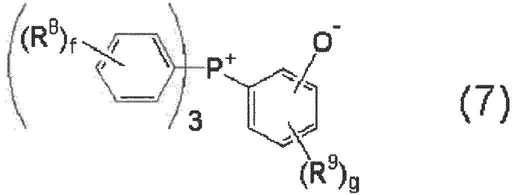

(In General Formula (7), P represents a phosphorus atom; R⁸ represents an alkyl group having 1 to 3 carbon atoms, and R⁹ represents a hydroxyl group; and f is a number of 0 to 5, and g is a number of 0 to 3.)

The compound represented by General Formula (7) can be produced, for example, as follows. First, a step where a triaromatic-substituted phosphine which is a tertiary phosphine is brought into contact with a diazonium salt to substitute the triaromatic-substituted phosphine with a diazonium group contained in the diazonium salt is carried out to obtain the compound represented by General Formula (7). However, the method is not limited to this.

Examples of the adduct of a phosphine compound and a quinone compound include a compound represented by General Formula (8).

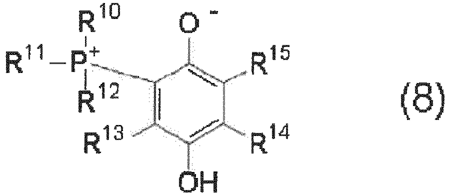

(In General Formula (8), P represents a phosphorus atom; R¹⁰, R¹¹, and R¹² each represent an alkyl group having 1 to 12 carbon atoms or an aryl group having 6 to 12 carbon atoms, and they may be the same as or different from each other; and R¹³, R¹⁴, and R¹⁵ each represent a hydrogen atom or a hydrocarbon group having 1 to 12 carbon atoms, where they may be the same as or different from each other, or R¹⁴ and R¹⁵ may be bonded to form a cyclic structure.)

As the phosphine compound used for the adduct of a phosphine compound and a quinone compound, for example, phosphines containing an aromatic ring, such as triphenylphosphine, tris(alkylphenyl)phosphine, tris(alkoxyphenyl)phosphine, trinaphthylphosphine, and tris(benzyl)phosphine, in which the aromatic ring may be unsubstituted or have a substituent such as an alkyl group and an alkoxy group are preferable.

Examples of the substituent such as an alkyl group and an alkoxy group include an alkyl group and an alkoxy group, each having 1 to 6 carbon atoms. From the viewpoint of easy availability, triphenylphosphine is preferable.

Examples of the quinone compound used for the adduct of a phosphine compound and a quinone compound include benzoquinone and anthraquinones.

Among these, from the viewpoint of storage stability, p-benzoquinone is preferable.

In a method of producing an adduct of a phosphine compound and a quinone compound, an organic tertiary phosphine can be brought into contact with a benzoquinone in a solvent that can dissolve both the organic tertiary phosphine and the benzoquinone and mixed to produce an adduct thereof. The solvent is preferably a solvent that is ketones such as acetone and methyl ethyl ketone and has a low solubility in the adduct. However, the method is not limited to this.

The compound represented by General Formula (8), in which R¹⁰, R¹¹, and R¹², all bonded to a phosphorus atom, are each preferably a phenyl group, and R¹³, R¹⁴, and R¹⁵ are each preferably a hydrogen atom, that is, the compound produced by adding 1,4-benzoquinone to triphenylphosphine is preferable since the compound decreases the modulus of elasticity during heating of a cured product of the thermosetting resin composition.

Examples of the adduct of a phosphonium compound and a silane compound that can be used in the thermosetting resin composition of the present embodiment include a compound represented by General Formula (9), where tetraphenylphosphonium bis(naphthalene-2,3-dioxy)phenylsilicate is preferable.

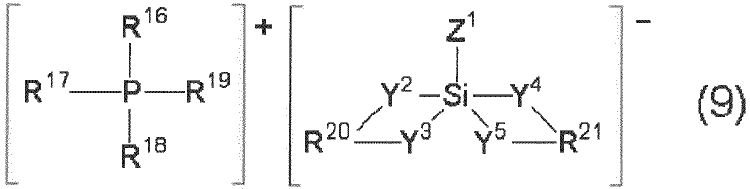

(In General Formula (9), P represents a phosphorus atom and Si represents a silicon atom; R¹⁶, R¹⁷, R¹⁸, and R¹⁹ each represent an organic group having an aromatic ring or a heterocyclic ring, or an aliphatic group, and they may be the same as or different from each other; in the formula, R²⁰ is an organic group which is bonded to groups Y² and Y³; in the formula, R²¹ is an organic group which is bonded to groups Y⁴ and Y⁵; Y² and Y³ each represent a group formed in a case where a proton-donating substituent releases a proton, and the groups Y² and Y³ in the same molecule are bonded to the silicon atom to form a chelate structure; Y⁴ and Y⁵ each represent a group formed in a case where a proton-donating substituent releases a proton, and the groups Y⁴ and Y⁵ in the same molecule are bonded to the silicon atom to form a chelate structure; R²⁰ and R²¹ may be the same as or different from each other, and the groups Y², Y³, Y⁴, and Y⁵ may be the same as or different from each other; and Z¹ is an organic group having an aromatic ring or a heterocyclic ring, or an aliphatic group.)

In General Formula (9), examples of R¹⁶, R¹⁷, R¹⁸, and R¹⁹ include a phenyl group, a methylphenyl group, a methoxyphenyl group, a hydroxyphenyl group, a naphthyl group, a hydroxynaphthyl group, a benzyl group, a methyl group, an ethyl group, a n-butyl group, a n-octyl group, and a cyclohexyl group, and among these, aromatic groups having a substituent such as an alkyl group, an alkoxy group, and a hydroxyl group, and unsubstituted aromatic groups, such as a phenyl group, a methylphenyl group, a methoxyphenyl group, a hydroxyphenyl group, and a hydroxynaphthyl group, are more preferable.

Moreover, in General Formula (9), R²⁰ is an organic group which is bonded to Y² and Y³. Similarly, R²¹ is an organic group which is bonded to the groups Y⁴ and Y⁵. Y² and Y³ are each a group formed in a case where a proton-donating substituent releases a proton, and the groups Y² and Y³ in the same molecule are bonded to the silicon atom to form a chelate structure. Similarly, Y⁴ and Y⁵ are each a group formed in a case where a proton-donating substituent releases a proton, and the groups Y⁴ and Y⁵ in the same molecule are bonded to the silicon atom to form a chelate structure. The groups R²⁰ and R²¹ may be the same as or different from each other, and the groups Y², Y³, Y⁴, and Y⁵ may be the same as or different from each other. The groups represented by -Y²-R²⁰-Y³- and Y⁴-R²¹-Y⁵- in General Formula (9) are each a group formed in a case where a proton donor releases two protons. As the proton donor, an organic acid having at least two carboxyl groups or hydroxyl groups in the molecule is preferable, an aromatic compound having at least two carboxyl groups or hydroxyl groups in the adjacent carbons constituting the aromatic ring is more preferable, and an aromatic compound having at least two hydroxyl groups in the adjacent carbons constituting the aromatic ring is still more preferable.

Examples thereof include catechol, pyrogallol, 1,2-dihydroxynaphthalene, 2,3-dihydroxynaphthalene, 2,2'-biphenol, 1,1'-bi-2-naphthol, salicylic acid, 1-hydroxy-2-naphthoic acid, 3-hydroxy-2-naphthoic acid, chloranilic acid, tannic acid, 2-hydroxybenzyl alcohol, 1,2-cyclohexanediol, 1,2-propanediol, and glycerin, but among these, catechol, 1,2-dihydroxynaphthalene, and 2,3-dihydroxynaphthalene are more preferable.

Furthermore, Z¹ in General Formula (9) is an organic group having an aromatic ring or a heterocyclic ring, or an aliphatic group. Specific examples thereof include aliphatic hydrocarbon groups such as a methyl group, an ethyl group, a propyl group, a butyl group, a hexyl group, and an octyl group, aromatic hydrocarbon groups such as a phenyl group, a benzyl group, a naphthyl group, and a biphenyl group, and reactive substituents such as an alkyl group having a glicydyloxy group, a mercapto group, or an amino group, such as a glycidyloxypropyl group, a mercaptopropyl group, and an aminopropyl group, and a vinyl group. Among these, a methyl group, an ethyl group, a phenyl group, a naphthyl group, and a biphenyl group are more preferable in view of thermal stability.

A method for producing an adduct of a phosphonium compound and a silane compound is as follows.

A silane compound such as phenyltrimethoxysilane and a proton donor such as 2,3-dihydroxynaphthalene are added to methanol in a flask, and dissolved.

Next, a sodium methoxide-methanol solution is added dropwise thereto under stirring at room temperature. A solution prepared by dissolving a tetra-substituted phosphonium halide such as tetraphenyl phosphonium bromide in methanol in advance is added to the resulting reaction product dropwise under stirring at room temperature to precipitate crystals. The precipitated crystals are filtered, washed with water, and dried in vacuum to obtain an adduct of the phosphonium compound and the silane compound. However, the method is not limited to this.

A content of the component (E) when the thermosetting resin composition contains the component (E) is preferably equal to or more than 0.1% by mass, is more preferably equal to or more than 0.15% by mass, and is even more preferably equal to or more than 0.25% by mass, with respect to a total mass of the thermosetting resin composition, from the viewpoint of effectively improving curability when molding.

Meanwhile, a content of the curing accelerator is preferably equal to or less than 1% by mass and is more preferably equal to or less than 0.8% by mass with respect to a total mass of the thermosetting resin composition from the viewpoint of improving fluidity when molding.

In addition, the thermosetting resin composition may contain at least one kind of thermally stable organic metal chelate complex, in addition to the component (C): non-conductive metal compound.

In addition, the thermosetting resin composition may further contain a curing agent. The curing agent can be broadly divided into three types such as, for example, a polyaddition-type curing agent, a catalyst-type curing agent, and a condensation-type curing agent. Among them, one kind may be used alone, or two or more kinds may be used in combination.

Examples of the polyaddition-type curing agent include one or two or more selected from the group consisting of polyamine compounds including dicyandiamide (DICY), organic acid dihydrazide, and the like as well as aliphatic polyamines such as diethylenetriamine (DETA), triethylenetetramine (TETA), and metaxylylenediamine (MXDA), aromatic polyamines such as diaminodiphenylmethane (DDM), m-phenylenediamine (MPDA), and diaminodiphenylsulfone (DDS); acid anhydrides including alicyclic acid anhydrides such as hexahydrophthalic anhydride (HHPA) and methyltetrahydrophthalic anhydride (MTHPA), aromatic acid anhydrides such as trimellitic anhydride (TMA), pyromellitic anhydride (PMDA), and benzophenonetetracarboxylic acid anhydride (BTDA), and the like; phenol resin-based curing agents such as a novolac-type phenol resin, a polyvinylphenol, and an aralkyl-type phenol resin; polymercaptan compounds such as a polysulfide, a thioester, and a thioether; isocyanate compounds such as an isocyanate prepolymer and a blocked isocyanate; and organic acids such as a carboxylic acid-containing polyester resin.

Examples of the catalyst-type curing agent include one or two or more selected from the group consisting of tertiary amine compounds such as benzyldimethylamine (BDMA) and 2,4,6-trisdimethylaminomethylphenol (DMP-30); imidazole compounds such as 2-methylimidazole and 2-ethyl-4-methylimidazole (EMI24); and Lewis acids such as BF₃ complexes.

Examples of the condensation-type curing agent include one or two or more selected from the group consisting of a resol-type phenol resin; urea resins such as a methylol group-containing urea resin; and melamine resins such as a methylol group-containing melamine resin.

Among these, from the viewpoint of improving a balance of flame resistance, moisture resistance, electrical characteristics, curability, storage stability, and the like, the phenol resin-based curing agents are more preferably included. As the phenol resin-based curing agents, all of monomers, oligomers, and polymers, each having two or more phenolic hydroxyl groups in one molecule, can be used, and molecular weights and molecular structures thereof are not limited.

Examples of the phenol resin-based curing agents include one or two or more selected from the group consisting of novolac-type phenol resins such as a phenol-novolac resin, a cresol-novolac resin, and bisphenol novolac; polyfunctional phenol resins such as a polyvinyl phenol and a triphenolmethane phenol resin; modified phenol resins such as a terpene-modified phenol resin and a dicyclopentadiene-modified phenol resin; phenol aralkyl-type phenol resins such as a phenol aralkyl resin having a phenylene skeleton and/or a biphenylene skeleton, and a naphthol aralkyl resin having a phenylene and/or a biphenylene skeleton; and bisphenol compounds such as bisphenol A and bisphenol F. Among these, from the viewpoint of reducing the warp of a molded product, a novolac-type phenol resin, a polyfunctional phenol resin, and a phenol aralkyl-type phenol resin are more preferably included. Further, a phenol novolac resin, a phenol aralkyl resin having a biphenylene skeleton, or a triphenylmethane-type phenol resin modified with formaldehyde can also be preferably used.

A content of the curing agent in the thermosetting resin composition is preferably equal to or more than 0.5% by mass, is more preferably equal to or more than 1% by mass, and is even more preferably equal to or more than 1.5% by mass, with respect to a total mass of the thermosetting resin composition, from the viewpoint of realizing excellent fluidity when molding and improving fillability and moldability.

Meanwhile, a content of the curing agent is preferably equal to or less than 9% by mass, is more preferably equal to or less than 8% by mass, and is even more preferably equal to or less than 7% by mass, with respect to a total mass of the thermosetting resin composition, from the viewpoint of improving moisture resistance reliability and reflow resistance of an electronic component and reducing warp of a molded product to be obtained.

In addition, the thermosetting resin composition of the present embodiment may contain additives, for example, such as a release agent, a flame retardant, an ion trapping agent, a coloring agent, a low-stress agent, and an antioxidant, as desired. Among them, one kind may be used alone, or two or more kinds may be used in combination.

An amount of each of these components in the thermosetting resin composition can be set to about 0.01% to 2% by mass with respect to a total mass of the thermosetting resin composition.

Examples of the release agent include one or two or more selected from natural wax such as carnauba wax; synthetic wax such as montanic acid ester wax such as glycerin trimontanate, and polyethylene oxide wax; a higher fatty acid or a metal salt thereof such as zinc stearate; and paraffin.

Examples of the flame retardant include one or two or more selected from aluminum hydroxide, magnesium hydroxide, zinc borate, zinc molybdate, and a phosphazene.

Examples of the ion trapping agent include one or two or more selected from hydrotalcites or hydrated oxides of elements selected from magnesium, aluminum, bismuth, titanium, and zirconium.

Examples of the coloring agent include one or two or more selected from carbon black, bengala (red iron oxide), and titanium oxide.

Examples of the low-stress agent include one or two or more selected from a polybutadiene compound; an acrylonitrilebutadiene copolymerized compound; and a silicone compound such as a silicone oil and silicone rubber.

Furthermore, the thermosetting resin composition of the present embodiment preferably adopts a configuration in which carbon such as carbon black used as the coloring agent is not contained, from the viewpoint of improving plating deposit characteristics.

In a method for producing the thermosetting resin composition of the present embodiment, for example, the respective components of the thermosetting resin composition are mixed by a known unit to obtain a mixture. Further, the mixture is melt-kneaded to obtain a kneaded product. As the kneading method, for example, an extruder such as a monoaxial kneading extruder and a biaxial kneading extruder, or a roll-type kneader such as a mixing roll can be used, but the biaxial kneading extruder is preferably used. After cooling, the kneaded product can be formed into a predetermined shape.

Since the thermosetting resin composition obtainable in the present embodiment contains the components (A) to (D), and the type of the component (A) and a size of the component (B) are appropriately selected, it is possible to obtain a cured product thereof which has excellent plating deposit characteristics when being fine processed by LDS, and it is also possible to reduce an interconnect width and an interconnect interval when forming a circuit.

The shape of the thermosetting resin composition may be a predetermined shape such as, for example, a powdery, granular, tablet, or sheet shape. In this manner, a thermosetting resin composition suitable for a known molding method such as transfer molding, injection molding, and compression molding can be obtained.

The thermosetting resin composition in a powdery shape means a pulverized product obtained by pulverizing the obtained kneaded product, the thermosetting resin composition in a granular shape means an aggregate obtained by solidifying powders (kneaded powdery products) of the thermosetting resin composition or a granule obtained by a known granulation method, the thermosetting resin composition in a tablet shape means a shaped product formed into a predetermined shape by tablet-molding the thermosetting resin composition at a high pressure, the thermosetting resin composition in a sheet shape means a resin film formed of a thermosetting resin composition in a sheet-like shape or rollable roll shape.

In the present embodiment, the thermosetting resin composition in the powdery, granular, tablet, or sheet shape may be in a semi-cured state (stage B state).

Examples of the method for molding the thermosetting resin composition in the present embodiment include mold forming such as injection molding and transfer molding. By using such a molding method, it is possible to produce a resin molded article including a cured product of the thermosetting resin composition.

In the present embodiment, a resin molded article is a cured product of the thermosetting resin composition containing an LDS additive, and it is specifically a resin molded article having a three-dimensional structure. A shape of the resin molded article is not limited as long as it has a three-dimensional structure, and for example, a part thereof may be a curved surface.

An MID can be obtained by subjecting the resin molded article to LDS.

The MID is a device having three elements of a three-dimensional shape, the resin molded article, a three-dimensional circuit, and is, for example, a part formed into a circuit with a metal film on a surface of the resin molded article of the three-dimensional structure. Specific examples of the MID include a resin molded article having a three-dimensional structure, and a three-dimensional circuit formed on the surface of the resin molded article. By using such an MID, the space can be effectively utilized, and it is thus possible to reduce the number of components or to realize a lightness, thinness, shortness and smallness of the components.

In the present embodiment, a manufacturing step of the MID can include each of producing a thermosetting resin composition for use in LDS, molding the thermosetting resin composition, irradiating an obtained resin molded article with active energy rays, and forming a circuit by a plating treatment. In addition, a surface washing step can be added before the plating treatment.

As the active energy rays with which the resin molded article is irradiated, for example, a laser can be used. The laser can be appropriately selected from known laser, for example, such as YAG laser, excimer laser, and electron beams, and the YGA laser is preferable. Further, the wavelength of the laser is also not determined, but is, for example, 200 nm to 12,000 nm. Among these, preferably, 248 nm, 308 nm, 355 nm, 532 nm, 1064 nm, or 10,600 nm may be used.

In the present embodiment, since the thermosetting resin composition contains the components (A) to (D), and the type of the component (A) and a size of the component (B) are appropriately selected, it is also possible to reduce an interconnect width and an interconnect interval when forming a circuit by irradiating the resin molded article formed of a cured product with a laser.

As the plating treatment, any one of electric field plating or electroless plating may be used. By subjecting the above-mentioned region irradiated with laser to a plating treatment, a circuit (plated layer) can be formed. The plating liquid is not determined, and a wide range of known plating liquids can be employed, and as the metal component, a plating liquid in which copper, nickel, gold, silver, and palladium are mixed may be used.

In the present embodiment, since the thermosetting resin composition contains the components (A) to (D), and the type of the component (A) and a size of the component (B) are appropriately selected, moldability of the thermosetting resin composition is excellent, and plating deposit characteristics of the resin molded article formed of a cured product are also excellent.

In the present embodiment, the resin molded article formed of a cured product of the thermosetting resin composition is not limited to a final product, but can also encompass composite materials or various components. The resin molded article can be used as a portable electronic device, components of vehicles or medical equipment, other electronic components including electrical circuits, semiconductor encapsulation materials, or composite materials for forming these. In addition, the MID can also be applied to a mobile phone or smartphone, built-in antenna, a sensor, or a semiconductor device.

In the following embodiments, the points different from those of the first embodiment will be mainly described.

### (Second embodiment)

When the inventor of the present invention examined a resin composition applied to LDS, it became clear that there is room for improvement in terms of manufacturing stability of a cured product of a resin composition, plating deposit characteristics in the fine processing by LDS, and miniaturization during circuit formation.

The present embodiment provides a resin composition which has excellent manufacturing stability of a cured product of the resin composition and excellent plating deposit characteristics when being fine processed by LDS, and which enables reduction in interconnect width and interconnect interval when forming a circuit.

According to the present embodiment,
there is provided a granular thermosetting resin composition for laser direct structuring (LDS) which is used for LDS, the thermosetting resin composition for LDS including:
a thermosetting resin;
an inorganic filler;
a non-conductive metal compound that forms a metal nucleus upon irradiation with active energy rays; and
a coupling agent,
in which the thermosetting resin contains one or more selected from the group consisting of an epoxy resin and a bismaleimide resin, and
an angle of fall of the thermosetting resin composition for LDS is equal to or less than 35°.

Any combination of these configurations, and the conversion of the expression of the present embodiment between methods, devices, and the like are also effective as aspects of the present embodiment.

For example, according to the present embodiment, it is possible to obtain a resin molded article including a cured product of the thermosetting resin composition for LDS of the present embodiment.

Furthermore, according to the present embodiment,
a three-dimensional molded interconnect device can also be obtained, the three-dimensional molded interconnect device including:
the resin molded article of the present embodiment having a three-dimensional structure; and
a three-dimensional circuit formed on a surface of the resin molded article.

According to the present embodiment, it is possible to provide a resin composition which has excellent manufacturing stability of a cured product of the resin composition and excellent plating deposit characteristics when being fine processed by LDS, and which enables reduction in interconnect width and interconnect interval when forming a circuit.

In the present embodiment, the thermosetting resin composition is a granular thermosetting resin composition for LDS, which is used for LDS.

In the present embodiment, the thermosetting resin composition for LDS (hereinafter, also simply referred to as a "thermosetting resin composition") is granular and contains the following components (A) to (D).
(A) A thermosetting resin;
(B) An inorganic filler;
(C) A non-conductive metal compound that forms a metal nucleus upon irradiation with active energy rays; and
(D) A coupling agent

The component (A) contains one or more selected from the group consisting of an epoxy resin and a bismaleimide resin. In addition, an angle of fall of the thermosetting resin composition is equal to or less than 35°.

In the present embodiment, by using the thermosetting resin composition for the resin composition for LDS, appropriately selecting its components, setting a shape of the thermosetting resin composition to be granular, and appropriately selecting an angle of fall of the thermosetting resin composition, it is possible to obtain a thermosetting resin composition having excellent manufacturing stability when molding it, and a cured product of the thermosetting resin composition which has excellent plating deposit characteristics when being fine processed by LDS, and it is also possible to reduce an interconnect width and an interconnect interval when forming a circuit.

In the present embodiment, an angle of fall of the thermosetting resin composition is an index showing fluidity, and it is equal to or less than 35°. Accordingly, when the granular thermosetting resin composition is transported using a transport unit such as a vibration feeder, it is possible to stably transport it without causing fixation, clogging, or the like. Thereby, molding stability can be improved. From the same viewpoint, an angle of fall of the thermosetting resin composition is preferably equal to or less than 35°, is more preferably equal to or less than 30°, and is even more preferably equal to or less than 25°.

A lower limit value of the angle of fall is not limited, it is, for example, equal to or more than 1° and is preferably equal to or more than 10°, because as an angle of fall becomes small, fixation, clogging, and the like are unlikely to occur.

An angle of fall is measured by the following method. That is, first, the granular thermosetting resin composition is dropped to be deposited on a horizontal plate having a certain area from holes of a funnel until it becomes a certain shape, and thereby a conical granular body is formed. Next, a weight having a certain weight on a same pedestal as the horizontal plate is dropped to impart a certain impact to the granular body, and a part of the granular thermosetting resin composition naturally flows and falls off from the horizontal plate. Thereafter, it is possible to obtain an angle of fall of the remaining conical granular body as an angle of elevation from the point on the outer periphery of the bottom surface to the apex of the cone. In addition, an angle of elevation of the granular body before the impact is made is called an angle of repose, and a difference between the angle of fall and the angle of repose is called an angle of difference.

Examples of devices for measuring the angle of fall and the angle of repose include a powder tester (manufactured by Hosokawa Micron Corporation).

The angle of difference of the thermosetting resin composition is an index indicating easiness of collapse of the granular thermosetting resin composition by vibration or the like from a transfer device such as a vibration feeder. It may be, for example, equal to or more than 5°, is preferably equal to or more than 10°, is more preferably equal to or more than 12°, and is even more preferably equal to or more than 15°, from the viewpoint of improving molding stability by improving transportation stability. Furthermore, specifically, an angle of difference of the thermosetting resin composition is equal to or less than an angle of repose.

A particle size dso of the thermosetting resin composition is preferably equal to or less than 1.0 mm, is more preferably equal to or less than 0.5 mm, and is even more preferably equal to or less than 0.3 mm, from the viewpoint of reducing a plated interconnect width after laser processing.

Furthermore, a particle size d₅₀ of the thermosetting resin composition is, for example, equal to or more than 100 µm, and is preferably equal to or more than 200 µm, from the viewpoint that then, handleability of the thermosetting resin composition is more preferable.

A particle size distribution of the thermosetting resin composition can be measured based on a particle size distribution of particles in terms of a volume using a commercially available laser diffraction particle size distribution analyzer (for example, SALD-7000 manufactured by Shimadzu Corporation).

Next, the components contained in the thermosetting resin composition will be described.

### (Component (A))

The component (A) is a thermosetting resin. The component (A) contains one or more selected from the group consisting of an epoxy resin and a bismaleimide resin, from the viewpoint of improving plating deposit characteristics in the fine processing by LDS, and reducing an interconnect width and an interconnect interval when forming a circuit.

Furthermore, the component (A) preferably contains an epoxy resin, and it is more preferably an epoxy resin, from the viewpoint of improving curability, preservability, heat resistance, moisture resistance, and chemical resistance.

Meanwhile, the component (A) preferably contains a bismaleimide resin, and it is more preferably a bismaleimide resin, from the viewpoint of obtaining more excellent heat resistance.

As an epoxy resin, an entirety of monomers, oligomers, or polymers having two or more epoxy groups within one molecule can be used, and their molecular weights or molecular structures are not limited.

The epoxy resin includes, for example, one or two or more selected from the group consisting of the various epoxy resins described above in the first embodiment.

From the viewpoint of reducing the warp of a molded product obtainable by curing the thermosetting resin composition or improving a balance of all the characteristics such as fillability, heat resistance, and moisture resistance, among those, the novolac-type epoxy resins, the polyfunctional epoxy resins, or the phenol aralkyl-type epoxy resins can be preferably used. Furthermore, from the same viewpoint, the epoxy resin preferably includes one or more selected from the group consisting of an orthocresol novolac-type epoxy resin, a phenol aralkyl-type epoxy resin having a biphenylene skeleton, and a triphenylmethane-type epoxy resin, and more preferably includes one or more selected from the group consisting of an orthocresol novolac-type epoxy resin and a phenol aralkyl-type epoxy resin having a biphenylene skeleton.

In addition, the bismaleimide resin is a (co)polymer of a compound having two or more maleimide groups.

The compound having two or more maleimide groups includes, for example, at least one of the compound represented by General Formula (1) and the compound represented by General Formula (2) which are described in the first embodiment. Accordingly, a glass transition temperature of a cured product of the thermosetting resin composition can be increased, and heat resistance of the cured product can be improved more effectively.

Furthermore, the component (A) may further contain another thermosetting resin. Examples of such thermosetting resins include one or two or more selected from the group consisting of the various resins described above in the first embodiment.

Furthermore, the component (A) may contain a resin curing agent such as a phenol resin curing agent to be described later.

A content of the component (A) in the thermosetting resin composition is preferably equal to or more than 1% by mass, is more preferably equal to or more than 2% by mass, and is even more preferably equal to or more than 2.5% by mass, with respect to a total mass of the thermosetting resin composition, from the viewpoint of improving fluidity when molding and improving fillability and molding stability.

Meanwhile, a content of the component (A) is preferably equal to or less than 15% by mass, is more preferably equal to or less than 14% by mass, and is even more preferably equal to or less than 13% by mass, with respect to a total mass of the thermosetting resin composition, from the viewpoint of improving moisture resistance reliability and reflow resistance and reducing warp of a molded product.

In the present embodiment, a content with respect to a total amount of the thermosetting resin composition refers to a content with respect to the total solid content resulting from the removal of a solvent in the thermosetting resin composition in a case where the thermosetting resin composition includes the solvent. The solid content of the thermosetting resin composition refers to non-volatile components in the thermosetting resin composition, and refers to a residue resulting from the removal of volatile components such as water and solvents.

### (Curing agent)

The thermosetting resin composition may contain a curing agent. The curing agent can be broadly divided into three types such as, for example, a polyaddition-type curing agent, a catalyst-type curing agent, and a condensation-type curing agent. Among them, one kind may be used alone, or two or more kinds may be used in combination.

The polyaddition-type curing agent contains, for example, one or two or more selected from the group consisting of the various acid anhydrides described above in the first embodiment, the various phenol resin-based curing agents described above in the first embodiment, the various polymercaptan compounds described above in the first embodiment, the various isocyanate compounds described above in the first embodiment, and the various organic acids described above in the first embodiment.

The catalyst-type curing agent includes, for example, one or two or more selected from the group consisting of the various types described above in the first embodiment.

The condensation-type curing agent includes, for example, one or two or more selected from the group consisting of the various resins described above in the first embodiment.

Among these, from the viewpoint of improving a balance of flame resistance, moisture resistance, electrical characteristics, curability, storage stability, and the like, the phenol resin-based curing agents are more preferably included. Examples of the phenol resin-based curing agents include those described above in the first embodiment.

The phenol resin-based curing agent more preferably includes a novolac-type phenol resin, a polyfunctional phenol resin, and a phenol aralkyl-type phenol resin, from the viewpoint of reducing the warp of a molded product. Further, a phenol novolac resin, a phenol aralkyl resin having a biphenylene skeleton, or a triphenylmethane-type phenol resin modified with formaldehyde can also be preferably used.

A content of the curing agent in the thermosetting resin composition is preferably equal to or more than 0.5% by mass, is more preferably equal to or more than 1% by mass, and is even more preferably equal to or more than 1.5% by mass, with respect to a total mass of the thermosetting resin composition, from the viewpoint of realizing excellent fluidity when molding and improving fillability and moldability.

Meanwhile, a content of the curing agent is preferably equal to or less than 9% by mass, is more preferably equal to or less than 8% by mass, and is even more preferably equal to or less than 7% by mass, with respect to a total mass of the thermosetting resin composition, from the viewpoint of improving moisture resistance reliability and reflow resistance of an electronic component and reducing warp of a molded product to be obtained.

### (Component (B))

The component (B) is an inorganic filler. The component (B) includes, for example, one or two or more materials selected from the group consisting of the various types described above in the first embodiment. The component (B) preferably includes silica such as molten crushed silica, molten spherical silica, and crystalline silica, and it is more preferably silica, from the viewpoint that then, mechanical properties or thermal properties of a cured product of the thermosetting resin composition are preferable.

A d₅₀ particle size of the component (B) may be, for example, equal to or less than 10 µm, is preferably equal to or less than 5 µm, is more preferably equal to or less than 3 µm, and is even more preferably equal to or less than 2 µm, from the viewpoint of reducing a plated interconnect width after laser processing.

Meanwhile, a d₅₀ particle size of the component (B) is, for example, equal to or more than 0.1 µm, and is more preferably equal to or more than 0.5 µm, from the viewpoint of improving moldability.

A particle size distribution of the inorganic filler can be measured based on a particle size distribution of particles in terms of a volume using a commercially available laser diffraction particle size distribution analyzer (for example, SALD-7000 manufactured by Shimadzu Corporation).

A content of the component (B) in the thermosetting resin composition is preferably equal to or more than 65% by mass, is more preferably equal to or more than 70% by mass, and is even more preferably equal to or more than 75% by mass, with respect to a total mass of the thermosetting resin composition, from the viewpoint of improving heat resistance and moisture resistance of a cured product.

Meanwhile, a content of the component (B) is preferably equal to or less than 95% by mass, is more preferably equal to or less than 90% by mass, and is even more preferably equal to or less than 85% by mass, with respect to a total mass of the thermosetting resin composition, from the viewpoint of more effectively improving fluidity and fillability of the thermosetting resin composition when molding.

### (Component (C))

The component (C) is a non-conductive metal compound that forms a metal nucleus upon irradiation with active energy rays. Such a compound acts as an LDS additive. Specifically, the configuration described above in the first embodiment can be applied to the component (C).

A content of the component (C) in the thermosetting resin composition is, for example, equal to or more than 2% by mass, is preferably equal to or more than 4% by mass, and is more preferably equal to or more than 8% by mass, with respect to a total mass of the thermosetting resin composition, from the viewpoint that then, plating deposit characteristics of a cured product of the thermosetting resin composition is favorable. Furthermore, a content of the component (C) is, for example, equal to or less than 20% by mass, is preferably equal to or less than 18% by mass, and is more preferably equal to or less than 15% by mass, with respect to a total mass of the thermosetting resin composition, from the viewpoint of reducing a decrease in insulating properties and an increase in dielectric loss tangent in a cured product of the thermosetting resin composition, and from the viewpoint that then, fluidity of the thermosetting resin composition is favorable in a case where a shape of the component (C) is non-spherical.

Furthermore, a total content of the component (B) and the component (C) in the thermosetting resin composition is preferably equal to or more than 70% by mass, is more preferably equal to or more than 75% by mass, is even more preferably equal to or more than 80% by mass, and is still more preferably equal to or more than 85% by mass, with respect to a total mass of the thermosetting resin composition from the viewpoint of improving resin mechanical properties and resin strength.

Meanwhile, a total content of the component (B) and the component (C) is preferably equal to or less than 98% by mass and is more preferably equal to or less than 95% by mass with respect to a total mass of the thermosetting resin composition from the viewpoint of improving moldability.

### (Component (D))

The component (D) is a coupling agent. Specifically, the configuration described above in the first embodiment can be applied to the component (D).

A content of the component (D) in the thermosetting resin composition is preferably equal to or more than 0.01% by mass, is more preferably equal to or more than 0.05% by mass, and is even more preferably equal to or more than 0.1% by mass, with respect to a total mass of the thermosetting resin composition, from the viewpoint that a flow length of the thermosetting resin composition is increased, and thereby moldability is improved.

Meanwhile, a content of the component (D) is preferably equal to or less than 1% by mass, is more preferably equal to or less than 0.8% by mass, and is even more preferably equal to or less than 0.6% by mass, with respect to a total mass of the thermosetting resin composition, from the viewpoint that an increase in water-absorbing properties of a cured product of the thermosetting resin composition is reduced, and thereby favorable anti-rust properties are obtained.

### (Other components)

In the present embodiment, the thermosetting resin composition may contain components other than the above-described components.

For example, the thermosetting resin composition may further contain (E) a curing accelerator.

### (Component (E))

The component (E) is a curing accelerator. Specifically, the configuration described above in the first embodiment can be applied for the curing accelerator.

A content of the component (E) when the thermosetting resin composition contains the component (E) is preferably equal to or more than 0.1% by mass, is more preferably equal to or more than 0.15% by mass, and is even more preferably equal to or more than 0.25% by mass, with respect to a total mass of the thermosetting resin composition, from the viewpoint of effectively improving curability when molding.

Meanwhile, a content of the curing accelerator is preferably equal to or less than 1% by mass and is more preferably equal to or less than 0.8% by mass with respect to a total mass of the thermosetting resin composition from the viewpoint of improving fluidity when molding.

In addition, the thermosetting resin composition may contain at least one kind of thermally stable organic metal chelate complex, in addition to the component (C): non-conductive metal compound.

In addition, the thermosetting resin composition of the present embodiment may contain additives, for example, such as a release agent, a flame retardant, an ion trapping agent, a coloring agent, a low-stress agent, and an antioxidant, as desired. Among them, one kind may be used alone, or two or more kinds may be used in combination. Specifically, the configuration described above in the first embodiment can be applied to these additives.

An amount of each of these components in the thermosetting resin composition can be set to about 0.01% to 2% by mass with respect to a total mass of the thermosetting resin composition.

Furthermore, the thermosetting resin composition of the present embodiment preferably adopts a configuration in which carbon such as carbon black used as the coloring agent is not contained, from the viewpoint of improving plating deposit characteristics.

In a method for producing the thermosetting resin composition of the present embodiment, for example, the respective components of the thermosetting resin composition are mixed by a known unit to obtain a mixture. Further, the mixture is melt-kneaded to obtain a kneaded product. As the kneading method, for example, an extruder such as a monoaxial kneading extruder and a biaxial kneading extruder, or a roll-type kneader such as a mixing roll can be used and the biaxial kneading extruder is preferably used. After cooling, the kneaded product may be formed into a granular shape.

Here, the granular thermosetting resin composition is specifically an aggregate obtained by solidifying powders (kneaded powdery products) of the thermosetting resin composition or a granule. The granular thermosetting resin composition may be in a semi-cured state (stage B state).

In addition, in the present embodiment, by sieving the obtained powder and granule when granulating the kneaded product, it is possible to obtain the granular thermosetting resin composition having an angle of fall within a predetermined range.

Examples of forming steps for producing the thermosetting resin composition formed into a granular shape include pulverizing a cooled mixture after melt-kneading. In addition, for example, a size of the granular body may be adjusted by sieving the thermosetting resin composition formed into a granular shape. Furthermore, for example, the thermosetting resin composition formed into a granular shape may be treated by a method such as a centrifugal milling method or a hot-cut method to prepare a degree of dispersion or fluidity.

Furthermore, examples of forming steps for producing a thermosetting resin composition formed into a pulverized shape include pulverizing a mixture to obtain a thermosetting resin composition formed into a granular shape, and thereafter further pulverizing the thermosetting resin composition formed into a granular shape.

Since the thermosetting resin composition obtainable in the present embodiment contains the predetermined components and is in the form of a granular shape exhibiting a predetermined angle of fall, a cured product of the resin composition has excellent manufacturing stability, and for example, it is possible to obtain a resin composition having excellent supply stability and moldability at the time of molding. Furthermore, according to the thermosetting resin composition obtained in the present embodiment its cured product has excellent plating deposit characteristics when being fine processed by LDS, and it is possible to reduce an interconnect width and an interconnect interval when forming a circuit.

Examples of the method for molding the thermosetting resin composition in the present embodiment include mold forming such as transfer molding, injection molding, and compression molding. By using such a molding method, it is possible to produce a resin molded article including a cured product of the thermosetting resin composition.

In the present embodiment, a resin molded article is a cured product of the thermosetting resin composition containing an LDS additive, and it is specifically a resin molded article having a three-dimensional structure. A shape of the resin molded article is not limited as long as it has a three-dimensional structure, and for example, a part thereof may be a curved surface.

In addition, the resin molded article formed of a cured product of the thermosetting resin composition is not limited to a final product, but can also encompass composite materials or various components. The resin molded article can be used as a portable electronic device, components of vehicles or medical equipment, other electronic components including electrical circuits, semiconductor encapsulation materials, or composite materials for forming these.

Furthermore, an MID can be obtained by subjecting the resin molded article to LDS.

The MID is a device having three elements of a three-dimensional shape, the resin molded article, a three-dimensional circuit, and is, for example, a part formed into a circuit with a metal film on a surface of the resin molded article of the three-dimensional structure. Specific examples of the MID include a resin molded article having a three-dimensional structure, and a three-dimensional circuit formed on the surface of the resin molded article. By using such an MID, the space can be effectively utilized, and it is thus possible to reduce the number of components or to realize a lightness, thinness, shortness and smallness of the components. The MID can also be applied to a mobile phone or smartphone, built-in antenna, a sensor, or a semiconductor device.

In the present embodiment, a step of manufacturing an MID can include, for example, each of the above-mentioned steps in the first embodiment. In addition, a surface washing step can be added before the plating treatment.

As the active energy rays with which the resin molded article is irradiated, for example, a laser can be used. As the laser, for example, the laser described above in the first embodiment can be used.

In the present embodiment, since the thermosetting resin composition for LDS is the thermosetting resin composition containing the components (A) to (D), and its shape is a granular shape exhibiting a predetermined angle of fall, it is also possible to reduce an interconnect width and an interconnect interval when forming a circuit by irradiating the resin molded article formed of a cured product with a laser.

As the plating treatment, any one of electric field plating or electroless plating may be used. By subjecting the above-mentioned region irradiated with laser to a plating treatment, a circuit (plated layer) can be formed. The plating liquid is not determined, and a wide range of known plating liquids can be employed, and as the metal component, a plating liquid in which copper, nickel, gold, silver, and palladium are mixed may be used.

In the present embodiment, since the thermosetting resin composition for LDS is the thermosetting resin composition containing the components (A) to (D), and its shape is a granular shape exhibiting a predetermined angle of fall, supply stability and moldability of the thermosetting resin composition are excellent, manufacturing stability of a cured product of the resin composition is excellent, and plating deposit characteristics of a resin molded article formed of the cured product are excellent.

### (Third embodiment)

The inventors of the present invention examined use of fine processing by LDS in manufacturing of semiconductor devices such as MIDs.

The present embodiment provides a method for manufacturing a semiconductor device which has excellent moldability of an encapsulating material and excellent plating deposit characteristics when being fine processed by LDS, and which enables reduction in interconnect width and interconnect interval when forming a circuit.

According to the present embodiment,
there is provided a method for manufacturing a semiconductor device, the method including:
encapsulating a semiconductor element, such that a surface of the semiconductor element is covered, with a cured product of a thermosetting resin composition for laser direct structuring (LDS) to form an encapsulating material;
irradiating a specific portion on a surface of the encapsulating material with active energy rays;
hydrophilizing the surface of the encapsulating material; and
selectively forming a metal layer in a region, which is irradiated with the active energy rays, on the surface of the encapsulating material,
in which the thermosetting resin composition for LDS contains:
   (A) a thermosetting resin;
   (B) an inorganic filler;
   (C) a non-conductive metal compound that forms a metal nucleus upon irradiation with active energy rays; and
   (D) a coupling agent, and
the component (A) contains one or more selected from the group consisting of an epoxy resin and a bismaleimide resin.

Any combination of these configurations, and the conversion of the expression of the present embodiment between methods, devices, and the like are also effective as aspects of the present embodiment.

For example, according to the present embodiment, it is also possible to provide a semiconductor device obtainable by the method for manufacturing a semiconductor device of the present embodiment.

According to the present embodiment, it is possible to provide a method for manufacturing a semiconductor device which has excellent moldability of an encapsulating material and excellent plating deposit characteristics when being fine processed by LDS, and which enables reduction in interconnect width and interconnect interval when forming a circuit.

### (Method for manufacturing semiconductor device)

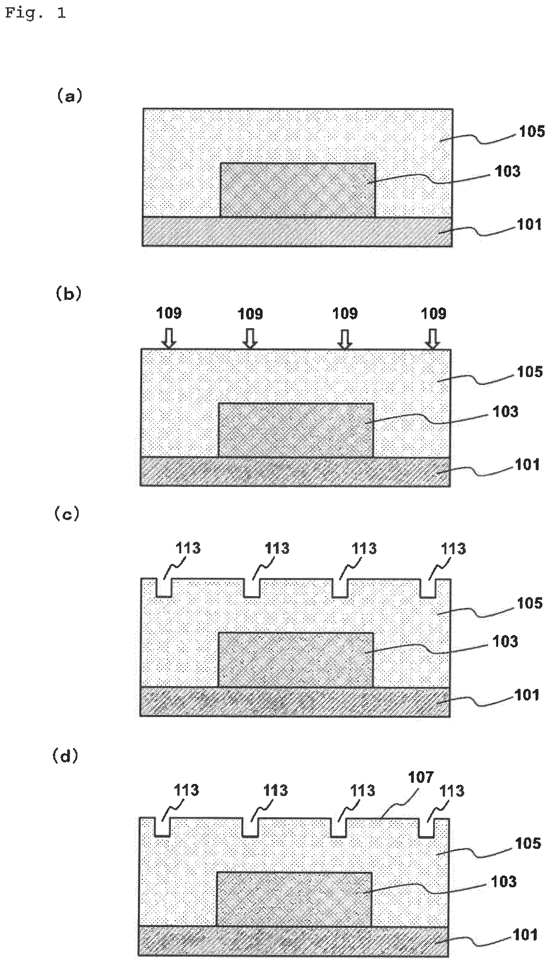

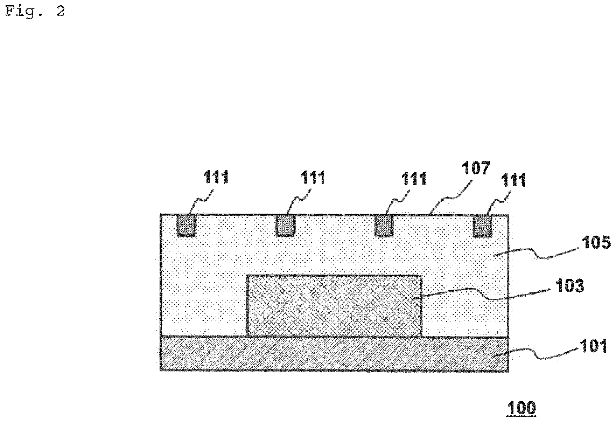

Fig. 1(a) to Fig. 1(d) and Fig. 2 are cross-sectional views each showing a manufacturing step for a semiconductor device in the present embodiment. Fig. 2 also shows a configuration of a semiconductor device 100 obtainable by such a manufacturing method.

The semiconductor device 100 (Fig. 2) includes a substrate 101, a semiconductor element 103 mounted on the substrate 101, an encapsulating material 105 that encapsulates the semiconductor element 103, and a metal layer 111 selectively provided in a predetermined region on a surface of the encapsulating material 105. The encapsulating material 105 is a cured product of a thermosetting resin composition containing an LDS additive.

Specific examples of the semiconductor device 100 include molded interconnect devices and various semiconductor packages.

Specific examples of molded interconnect devices include those used for automobile members.

Furthermore, specific examples of semiconductor packages include semiconductor packages such as Mold Array Package (MAP), Quad Flat Package (QFP), Small Outline Package (SOP), Chip Size Package (CSP), Quad Flat Non-leaded Package (QFN), Small Outline Non-leaded Package (SON), Ball Grid Array (BGA), Lead Flame BGA (LF-BGA), Flip Chip BGA (FCBGA), Molded Array Process BGA (MAPBGA), Embedded Wafer-Level BGA (eWLB), Fan-In type eWLB, and Fan-Out type eWLB; System In package (SIP); and the like.

A method for manufacturing the semiconductor device 100 includes the following steps 1 to 4.
(Step 1) encapsulating the semiconductor element 103, such that a surface of the semiconductor element 103 is covered, with a cured product of a thermosetting resin composition for laser direct structuring (LDS) to form the encapsulating material 105;
(Step 2) irradiating a specific portion on a surface of the encapsulating material 105 with active energy rays (laser 109);
(Step 3) hydrophilizing the surface of the encapsulating material 105; and
(Step 4) selectively forming the metal layer 111 in a region, which is irradiated with the laser 109, on the surface of the encapsulating material 105

The thermosetting resin composition for LDS (hereinafter, also simply referred to as a "thermosetting resin composition") contains (A) a thermosetting resin, (B) an inorganic filler, (C) a non-conductive metal compound that forms a metal nucleus upon irradiation with active energy rays, and (D) a coupling agent. In addition, the component (A) contains one or more selected from the group consisting of an epoxy resin and a bismaleimide resin.

Hereinafter, first, each of the steps will be specifically described, and the composition of the thermosetting resin composition for LDS will be described later.

### (Step 1)

In the step 1, the encapsulating material 105 for encapsulating the semiconductor element 103 is formed (Fig. 1(a)).

The semiconductor element 103 may be mounted on the substrate 101 prior to the step 1. The substrate 101 is, for example, an interconnect board such as an interposer, or a lead frame. Furthermore, the semiconductor element 103 is electrically connected to the substrate 101 by wire bonding, flip chip connection, or the like.

A method for molding the encapsulating material 105 mayf be selected according to components contained in the thermosetting resin composition, a shape of the thermosetting resin composition, and the like, and specific examples thereof include compression molding and transfer molding.

### (Step 2)

In the step 2, a specific portion on the surface of the encapsulating material 105 is selectively irradiated with active energy rays such as the laser 109 (Fig. 1(b)).

By irradiation with the laser 109, for example, a recessed part 113 can be formed at a portion of the encapsulating material 105 irradiated with the laser (Fig. 1(c)).

The laser 109 can be appropriately selected from known laser, for example, such as YAG laser, excimer laser, and electron beams, and the YGA laser is preferable. Further, the wavelength of the laser 109 is also not determined, but it is, for example, equal to or more than 200 nm and equal to or less than 2,000 nm, and from the viewpoint of thinning interconnects, it is preferably equal to or more than 240 nm and equal to or less than 1,100 nm. Among them, a laser having 248 nm, 308 nm, 355 nm, 515 nm, 532 nm, 1,064 nm, or 1,060 nm can be exemplified as the laser 109.

### (Step 3)

In the step 3, at least a part of the surface of the encapsulating material 105 is hydrophilized to form a hydrophilized surface 107 (Fig. 1(d)).

The hydrophilized surface 107 may be a part or the whole surface of the encapsulating material 105. Furthermore, the hydrophilized surface 107 may be any one of a flat surface or a curved surface, or may include both of them. Furthermore, the hydrophilized surface 107 preferably includes the entire region irradiated with the laser 109 in the step 2, from the viewpoint of improving plating deposit characteristics in the fine processing by LDS, and from the viewpoint of reducing an interconnect width and an interconnect interval when forming a circuit.

Specifically, the step 3 can be performed before or after the step 2.

The step 3 is preferably a step of hydrophilizing, after the step 2, the portion, which is irradiated with the laser, on the surface of the encapsulating material 105, specifically, an inner surface of the recessed part 113, from the viewpoint of removing the residue generated in the step 2 and forming the metal layer 111 more stably in the step 4.

Furthermore, the step 3 preferably includes applying a treatment liquid to the surface of the encapsulating material 105 from the viewpoint of stably hydrophilizing the surface of the encapsulating material 105. Furthermore, in the step 3, for example, the treatment liquid may be applied to the surface of the encapsulating material 105 and ultrasonically treated while being heated to about 40°C to 60°C.

Examples of the treatment liquid include glycol-based organic solvents, alcohol-based organic solvents, and lactone-based organic solvents.

Specific examples of glycol-based organic solvents include glycols such as ethylene glycol, diethylene glycol, triethylene glycol, and propylene glycol; glycol ethers such as diethylene glycol monomethyl ether, triethylene glycol monomethyl ether, propylene glycol monomethyl ether, propylene glycol monoethyl ether, and dipropylene glycol monomethyl ether; and glycol ether acetates such as ethylene glycol monomethyl ether acetate, propylene glycol monomethyl ether acetate, diethylene glycol monobutyl ether acetate, and diethylene glycol monoethyl ether acetate.

Specific examples of alcohol-based organic solvents include alcohol ethers having 3 or more and 8 or less carbon atoms, such as 3-methoxy-3-methyl-1-butanol.

Examples of lactone-based organic solvents include γ-butyrolactone, α-methyl-γ-butyrolactone, γ-valerolactone, γ-caprolactone, γ-laurolactone, δ-valerolactone, and hexanolactone.

The treatment liquid preferably contains a glycol-based organic solvent, and more preferably contains a glycol-based hydrophilic organic solvent, from the viewpoint of suitable hydrophilicization of the surface of the encapsulating material 105.

After forming the hydrophilized surface 107, the metal layer 111 is selectively formed in a predetermined region on the hydrophilized surface 107 by LDS. In LDS, specifically, a surface of a resin molded article containing an LDS additive is irradiated with active energy rays to generate a metal nucleus, and using the metal nucleus as a seed, a plated pattern is formed in a region irradiated with the energy rays by a plating treatment such as electroless plating. Conductive members such as interconnects and circuits can be formed based on this plated pattern. Hereinafter, a more specific description will be given.

### (Step 4)

In the step 4, the metal layer 111 is selectively formed on the portion, which is irradiated with the laser, on the surface of the encapsulating material 105, specifically, the recessed part 113 (Fig. 2). Specifically, the metal layer 111 is a plated film.

Furthermore, specifically, the step 4 includes applying a metal to the recessed part 113, and growing a plated layer formed from the metal in the recessed part 113.

As the plating treatment, any one of electric field plating or electroless plating may be used. By subjecting the above-mentioned region irradiated with the laser 109 in the step 2 to a plating treatment, a circuit (plated layer) can be formed. The plating liquid is not determined, and a wide range of known plating liquids can be employed, and as the metal component, a plating liquid in which copper, nickel, gold, silver, and palladium are mixed may be used.

The semiconductor device 100 is obtained by the above-described steps. In the present embodiment, the encapsulating material 105, which is a cured product of the thermosetting resin composition containing the components (A) to (D), is irradiated with the laser 109; the surface of the encapsulating material 105 including the region irradiated with the laser is hydrophilized; and thereafter, the metal layer 111 is formed on the hydrophilized surface 107. Thereby, it is possible to form a circuit directly in a desired region of the semiconductor device 100 such as a semiconductor package, and to reduce an interconnect width and an interconnect interval at that time. Furthermore, it is possible to obtain the semiconductor device 100 in which moldability of the encapsulating material 105 is excellent and plating deposit characteristics in the fine processing by DS is excellent.

In the above description, the configuration, in which the recessed part 113 is formed at the portion irradiated with the laser, and the metal layer 111 is grown in the recessed part 113 to form an interconnect, has been described as an example, but shapes and functions of the recessed part 113 and the corresponding metal layer 111 are not limited thereto, and for example, vias may be formed as the recessed parts 113. In the present embodiment, since the portion irradiated with the laser 109 is hydrophilized, the residue after the laser irradiation can be effectively removed even vias are formed. Accordingly, vias can be stably formed at a desired size and pitch.

Furthermore, in the above descriptions, the case, in which the step 3 for forming the hydrophilized surface 107 is performed after the step 2 for irradiation with the laser 109, has been described as an example, but the order of performing the steps 2 and 3 is not limited thereto. The step 3 may be performed before the step 2 to form the hydrophilized surface 107, and thereafter in the step 2, a specific region on the hydrophilized surface 107 may be selectively irradiated with the laser 109.

### (Thermosetting resin composition for LDS)

Next, a constitution of the thermosetting resin composition for LDS will be described. In the present embodiment, the thermosetting resin composition for LDS contains the above-mentioned components (A) to (D).

In the present embodiment, by hydrophilizing the encapsulating material 105 and appropriately selecting the type of the components contained in the thermosetting resin composition, it is possible to obtain a thermosetting resin composition having excellent moldability, and a cured product of the thermosetting resin composition which has excellent plating deposit characteristics when being fine processed by LDS, and it is also possible to reduce an interconnect width and an interconnect interval when forming a circuit.

The thermosetting resin composition is preferably constituted as described in the first embodiment from the viewpoint of further improving moldability of the thermosetting resin composition.

Furthermore, the thermosetting resin composition is preferably constituted as described in the second embodiment from the viewpoint of further improving manufacturing stability of the thermosetting resin composition when molding.

### (Component (A))

The component (A) is a thermosetting resin. The component (A) contains one or more selected from the group consisting of an epoxy resin and a bismaleimide resin, from the viewpoint of improving plating deposit characteristics in the fine processing by LDS, and reducing an interconnect width and an interconnect interval when forming a circuit.

Furthermore, the component (A) preferably contains an epoxy resin, and it is more preferably an epoxy resin, from the viewpoint of improving curability, preservability, heat resistance, moisture resistance, and chemical resistance.

Meanwhile, the component (A) preferably contains a bismaleimide resin, and it is more preferably a bismaleimide resin, from the viewpoint of obtaining more excellent heat resistance.

As an epoxy resin, an entirety of monomers, oligomers, or polymers having two or more epoxy groups within one molecule can be used, and their molecular weights or molecular structures are not limited.

The epoxy resin includes, for example, one or two or more selected from the group consisting of the various epoxy resins described above in the first embodiment.

From the viewpoint of reducing the warp of a molded product obtainable by curing the thermosetting resin composition or improving a balance of all the characteristics such as fillability, heat resistance, and moisture resistance, among those, the novolac-type epoxy resins, the polyfunctional epoxy resins, or the phenol aralkyl-type epoxy resins can be preferably used. Furthermore, from the same viewpoint, the epoxy resin preferably includes one or more selected from the group consisting of an orthocresol novolac-type epoxy resin, a phenol aralkyl-type epoxy resin having a biphenylene skeleton, and a triphenylmethane-type epoxy resin, and more preferably includes one or more selected from the group consisting of an orthocresol novolac-type epoxy resin and a phenol aralkyl-type epoxy resin having a biphenylene skeleton.

In addition, the bismaleimide resin is a (co)polymer of a compound having two or more maleimide groups.

The compound having two or more maleimide groups includes, for example, at least one of the compound represented by General Formula (1) and the compound represented by General Formula (2) which are described in the first embodiment. Accordingly, a glass transition temperature of a cured product of the thermosetting resin composition can be increased, and heat resistance of the cured product can be improved more effectively.

Furthermore, the component (A) may further contain another thermosetting resin. Examples of such thermosetting resins include one or two or more selected from the group consisting of the various resins described above in the first embodiment.

Furthermore, the component (A) may contain a resin curing agent such as a phenol resin curing agent to be described later.

A content of the component (A) in the thermosetting resin composition is preferably equal to or more than 1% by mass, is more preferably equal to or more than 2% by mass, and is even more preferably equal to or more than 2.5% by mass, with respect to a total mass of the thermosetting resin composition, from the viewpoint of improving fluidity when molding and improving fillability and molding stability.

Meanwhile, a content of the component (A) is preferably equal to or less than 15% by mass, is more preferably equal to or less than 14% by mass, and is even more preferably equal to or less than 13% by mass, with respect to a total mass of the thermosetting resin composition, from the viewpoint of improving moisture resistance reliability and reflow resistance and reducing warp of a molded product.

In the present embodiment, a content with respect to a total amount of the thermosetting resin composition refers to a content with respect to the total solid content resulting from the removal of a solvent in the thermosetting resin composition in a case where the thermosetting resin composition includes the solvent. The solid content of the thermosetting resin composition refers to non-volatile components in the thermosetting resin composition, and refers to a residue resulting from the removal of volatile components such as water and solvents.

### (Curing agent)

The thermosetting resin composition may contain a curing agent. The curing agent can be broadly divided into three types such as, for example, a polyaddition-type curing agent, a catalyst-type curing agent, and a condensation-type curing agent. Among them, one kind may be used alone, or two or more kinds may be used in combination.

The polyaddition-type curing agent contains, for example, one or two or more selected from the group consisting of the various acid anhydrides described above in the first embodiment, the various phenol resin-based curing agents described above in the first embodiment, the various polymercaptan compounds described above in the first embodiment, the various isocyanate compounds described above in the first embodiment, and the various organic acids described above in the first embodiment.

The catalyst-type curing agent includes, for example, one or two or more selected from the group consisting of the various types described above in the first embodiment.

The condensation-type curing agent includes, for example, one or two or more selected from the group consisting of the various resins described above in the first embodiment.

Among these, from the viewpoint of improving a balance of flame resistance, moisture resistance, electrical characteristics, curability, storage stability, and the like, the phenol resin-based curing agents are more preferably included. Examples of the phenol resin-based curing agents include those described above in the first embodiment.

The phenol resin-based curing agent more preferably includes a novolac-type phenol resin, a polyfunctional phenol resin, and a phenol aralkyl-type phenol resin, from the viewpoint of reducing the warp of a molded product. Further, a phenol novolac resin, a phenol aralkyl resin having a biphenylene skeleton, or a triphenylmethane-type phenol resin modified with formaldehyde can also be preferably used.

A content of the curing agent in the thermosetting resin composition is preferably equal to or more than 0.5% by mass, is more preferably equal to or more than 1% by mass, and is even more preferably equal to or more than 1.5% by mass, with respect to a total mass of the thermosetting resin composition, from the viewpoint of realizing excellent fluidity when molding and improving fillability and moldability.

Meanwhile, a content of the curing agent is preferably equal to or less than 9% by mass, is more preferably equal to or less than 8% by mass, and is even more preferably equal to or less than 7% by mass, with respect to a total mass of the thermosetting resin composition, from the viewpoint of improving moisture resistance reliability and reflow resistance of an electronic component and reducing warp of a molded product to be obtained.

### (Component (B))

The component (B) is an inorganic filler. The component (B) includes, for example, one or two or more materials selected from the group consisting of the various types described above in the first embodiment. The component (B) preferably includes silica such as molten crushed silica, molten spherical silica, and crystalline silica, and it is more preferably silica, from the viewpoint that then, mechanical properties or thermal properties of a cured product of the thermosetting resin composition are preferable.

A d₅₀ particle size of the component (B) may be, for example, equal to or less than 10 µm, is preferably equal to or less than 5 µm, is more preferably equal to or less than 3 µm, and is even more preferably equal to or less than 2 µm, from the viewpoint of reducing a plated interconnect width after laser processing.

Meanwhile, a d₅₀ particle size of the component (B) is, for example, equal to or more than 0.1 µm, and is more preferably equal to or more than 0.5 µm, from the viewpoint of improving moldability.

A particle size distribution of the inorganic filler can be measured based on a particle size distribution of particles in terms of a volume using a commercially available laser diffraction particle size distribution analyzer (for example, SALD-7000 manufactured by Shimadzu Corporation).

A content of the component (B) in the thermosetting resin composition is preferably equal to or more than 65% by mass, is more preferably equal to or more than 70% by mass, and is even more preferably equal to or more than 75% by mass, with respect to a total mass of the thermosetting resin composition, from the viewpoint of improving heat resistance and moisture resistance of a cured product.

Meanwhile, a content of the component (B) is preferably equal to or less than 95% by mass, is more preferably equal to or less than 90% by mass, and is even more preferably equal to or less than 85% by mass, with respect to a total mass of the thermosetting resin composition, from the viewpoint of more effectively improving fluidity and fillability of the thermosetting resin composition when molding.

### (Component (C))

The component (C) is a non-conductive metal compound that forms a metal nucleus upon irradiation with active energy rays. Such a compound acts as an LDS additive. Specifically, the configuration described above in the first embodiment can be applied to the component (C).

A content of the component (C) in the thermosetting resin composition is, for example, equal to or more than 2% by mass, is preferably equal to or more than 4% by mass, and is more preferably equal to or more than 8% by mass, with respect to a total mass of the thermosetting resin composition, from the viewpoint that then, plating deposit characteristics of a cured product of the thermosetting resin composition is favorable. Furthermore, a content of the component (C) is, for example, equal to or less than 20% by mass, is preferably equal to or less than 18% by mass, and is more preferably equal to or less than 15% by mass, with respect to a total mass of the thermosetting resin composition, from the viewpoint of reducing a decrease in insulating properties and an increase in dielectric loss tangent in a cured product of the thermosetting resin composition, and from the viewpoint that then, fluidity of the thermosetting resin composition is favorable in a case where a shape of the component (C) is non-spherical.

Furthermore, a total content of the component (B) and the component (C) in the thermosetting resin composition is preferably equal to or more than 70% by mass, is more preferably equal to or more than 75% by mass, is even more preferably equal to or more than 80% by mass, and is still more preferably equal to or more than 85% by mass, with respect to a total mass of the thermosetting resin composition from the viewpoint of improving resin mechanical properties and resin strength.

Meanwhile, a total content of the component (B) and the component (C) is preferably equal to or less than 98% by mass and is more preferably equal to or less than 95% by mass with respect to a total mass of the thermosetting resin composition from the viewpoint of improving moldability.

### (Component (D))

The component (D) is a coupling agent. Specifically, the configuration described above in the first embodiment can be applied to the component (D).

A content of the component (D) in the thermosetting resin composition is preferably equal to or more than 0.01% by mass, is more preferably equal to or more than 0.05% by mass, and is even more preferably equal to or more than 0.1% by mass, with respect to a total mass of the thermosetting resin composition, from the viewpoint that then, a flow length of the thermosetting resin composition is increased, and thereby moldability is improved.

Meanwhile, a content of the component (D) is preferably equal to or less than 1% by mass, is more preferably equal to or less than 0.8% by mass, and is even more preferably equal to or less than 0.6% by mass, with respect to a total mass of the thermosetting resin composition, from the viewpoint that then, an increase in water-absorbing properties of a cured product of the thermosetting resin composition is reduced, and thereby favorable anti-rust properties are obtained.

### (Other components)

The thermosetting resin composition may contain components other than the above-described components.

For example, the thermosetting resin composition may further contain (E) a curing accelerator.

### (Component (E))

The component (E) is a curing accelerator. Specifically, the configuration described above in the first embodiment can be applied for the curing accelerator.

A content of the component (E) when the thermosetting resin composition contains the component (E) is preferably equal to or more than 0.1% by mass, is more preferably equal to or more than 0.15% by mass, and is even more preferably equal to or more than 0.25% by mass, with respect to a total mass of the thermosetting resin composition, from the viewpoint of effectively improving curability when molding.

Meanwhile, a content of the curing accelerator is preferably equal to or less than 1% by mass and is more preferably equal to or less than 0.8% by mass with respect to a total mass of the thermosetting resin composition from the viewpoint of improving fluidity when molding.

In addition, the thermosetting resin composition may contain at least one kind of thermally stable organic metal chelate complex, in addition to the component (C): non-conductive metal compound.

In addition, the thermosetting resin composition may contain additives, for example, such as a release agent, a flame retardant, an ion trapping agent, a coloring agent, a low-stress agent, and an antioxidant, as desired. Among them, one kind may be used alone, or two or more kinds may be used in combination. Specifically, the configuration described above in the first embodiment can be applied to these additives.

An amount of each of these components in the thermosetting resin composition can be set to about 0.01% to 2% by mass with respect to a total mass of the thermosetting resin composition.

Furthermore, the thermosetting resin composition preferably adopts a configuration in which carbon such as carbon black used as the coloring agent is not contained, from the viewpoint of improving plating deposit characteristics.

In a method for producing the thermosetting resin composition, for example, the respective components of the thermosetting resin composition are mixed by a known unit to obtain a mixture. Further, the mixture is melt-kneaded to obtain a kneaded product. As the kneading method, for example, an extruder such as a monoaxial kneading extruder and a biaxial kneading extruder, or a roll-type kneader such as a mixing roll can be used, but the biaxial kneading extruder is preferably used. After cooling, the kneaded product can be formed into a predetermined shape.

The shape of the thermosetting resin composition may be a predetermined shape such as, for example, a powdery, granular, tablet, or sheet shape. In this manner, a thermosetting resin composition suitable for a known molding method such as transfer molding, injection molding, and compression molding can be obtained.

The thermosetting resin composition in a powdery shape means a pulverized product obtained by pulverizing the obtained kneaded product, the thermosetting resin composition in a granular shape means an aggregate obtained by solidifying powders (kneaded powdery products) of the thermosetting resin composition or a granule obtained by a known granulation method, the thermosetting resin composition in a tablet shape means a shaped product formed into a predetermined shape by tablet-molding the thermosetting resin composition at a high pressure, the thermosetting resin composition in a sheet shape means a resin film formed of a thermosetting resin composition in a sheet-like shape or rollable roll shape.

In the present embodiment, the thermosetting resin composition in the powdery, granular, tablet, or sheet shape may be in a semi-cured state (stage B state).

The embodiments of the invention have been described above but are only exemplary of the invention.

Thus, other various configurations may also be employed.

### [Examples]

Hereinafter, the present invention will be described in detail with reference to examples, but the present invention is not limited to the description of these examples.

### (Examples A1 to A4 and Comparative Examples A1 and A2)

Thermosetting resin compositions for LDS of each of the examples were prepared according to formulations shown in Table 1 and evaluated. Components used in each of the examples are as follows.

### (Inorganic filler)

Inorganic filler A1: Amorphous silica/crystalline silica, MUF-4V, manufactured by TATSUMORI LTD., average particle size 3.8 µm, specific surface area 4.0 m²/g

Inorganic filler A2: Silicon dioxide, SC-2500-SQ, manufactured by Admatechs Company Limited, average particle size 0.6 µm, specific surface area 6.4 m²/g

Inorganic filler A3: Silicon dioxide, SC-5500-SQ, manufactured by Admatechs Company Limited, average particle size 1.6 µm, specific surface area 4.4 m²/g

Inorganic filler A4: Silicon dioxide, TS-6026, manufactured by Micron Co., Ltd., average particle size 9.0 µm, specific surface area 3.4 m²/g

Inorganic filler A5: Silicon dioxide, TS-6021, manufactured by Micron Co., Ltd., average particle size 10.0 µm, specific surface area 3.5 m²/g

Inorganic filler A6: Silica, FB-560, manufactured by Denka Company Limited, average particle size 27.2 µm, specific surface area 1.5 m²/g

Inorganic filler A7: Silica, UF-305, manufactured by Tokuyama Corporation, average particle size 2.7 µm, specific surface area 2.1 m²/g

### (Coloring agent)

Coloring agent A1: Carbon black, carbon #5, manufactured by Mitsubishi Chemical Corporation

### (Coupling agent)

Coupling agent A1: 3-Mercaptopropyltrimethoxysilane, S810 manufactured by Chisso Corporation
Coupling agent A2: 3-Glicydoxypropyltrimethoxysilane, S510 manufactured by Chisso Corporation
Coupling agent A3: N-phenyl-γ-aminopropyltrimethoxysilane, CF-4083, manufactured by Dow Corning Toray Co., Ltd.

### (Thermosetting resin)

Epoxy resin A1: Orthocresol novolac-type epoxy resin, EOCN-1020, manufactured by Nippon Kayaku Co., Ltd.
Epoxy resin A2: Phenol aralkyl-type epoxy resin having a biphenylene skeleton, NC3000, manufactured by Nippon Kayaku Co., Ltd.

### (Curing agent)

Curing agent A1: Novolac-type phenol resin, PR-HF-3, manufactured by Sumitomo Bakelite Co., Ltd.
Curing agent A2: Phenol aralkyl-type resin having a biphenylene skeleton, MEH-7851SS, manufactured by Meiwa Plastic Industries, Ltd.

### (Curing accelerator)

Curing accelerator A1: Tetraphenylphosphonium bis(naphthalene-2,3-dioxy)phenylsilicate
Curing accelerator A2: Tetraphenylphosphonium-4,4'-sulfonyldiphenolate

### (Release agent)

Release agent A1: Glycerin trimontanic acid ester, Licolub WE4 manufactured by Clariant Japan Co., Ltd.
(Additive: non-conductive metal compound)
Additive A1: Inorganic composite oxide, 30C965, manufactured by The Shepherd Color Company

### (Silicone)

Silicone A1: Polyoxyalkylene epoxy-modified dimethylpolysiloxane, FZ-3730, manufactured by Dow Corning Toray Co., Ltd.

### (Low-stress agent)

Low-stress agent A1: Epoxy polybutadiene, JP-200, manufactured by Nippon Soda Co., Ltd.

### (Preparation of thermosetting resin composition)

The respective raw materials in the formulation amounts shown in Table 1 were mixed at normal temperature using a mixer, and then roll-kneaded at 70°C to 100°C. Subsequently, the obtained kneaded product was cooled, followed by pulverization, to obtain a thermosetting resin composition in a powdery shape. Then, for some of the examples, coarse particles and fine powder were removed using a sieve to obtain a powdery thermosetting resin composition.

### (Measurement of size of inorganic filler)

Particle size distributions, and d₁₀, d₅₀, and dₘₐₓ of the all inorganic fillers used in each of the examples were measured by a laser diffraction particle size distribution analyzer (SALD-7000, manufactured by Shimadzu Corporation).

### (Measurement of angle of fall of thermosetting resin composition)

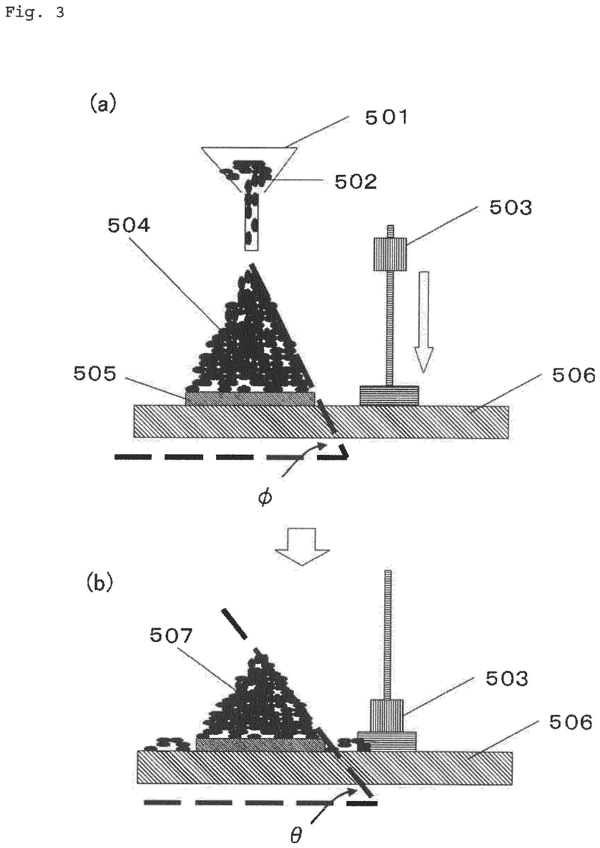

This measurement was performed by a method to be described later with reference to (a) of Fig. 3 and (b) of Fig. 3.

### (Evaluation method)

### (Moldability)

Molded products, with 50 mm × 50 mm × thickness 2 µm, of the resin compositions obtained in each of the examples were obtained under the condition of 175°C using a transfer molding machine. A sample of the obtained molded product was observed and evaluated according to the following evaluation standards.
A: Both of internal voids and external voids were not present
C: External voids were observed
D: Unfilled parts were present

### (Plating properties)

The resin compositions obtained in each of the examples were molded and cured under the condition of 175°C to obtain cured products. Surfaces of the obtained cured products were irradiated with YAG laser, and the plating properties in the regions irradiated with laser were evaluated in accordance with the following evaluation standards.
A: The plating surfaces do not have unevenness.
B: More or less unevenness is observed on the plating surfaces, but there is no area having plating missing.
C: Unevenness is observed on the plating surfaces, but there is no area having plating missing.
D: Severe unevenness is observed on the plating surfaces, and there is an area having plating missing.

### (L/S)

In the same manner as the above-described evaluation of plating properties, a molded product was created, a surface of the obtained resin molded product was irradiated with a UV laser, and a circuit having respective line widths was created. The narrowest pitched lines after conduction are listed in Table 1 as the results of each of the examples.

As evaluation levels, 7 levels of L/S = 20, 30, 40, 50, 75, 100, and 200 µm were used.

**Table 1**

| | | Example A1 | Example A2 | Example A3: | Example A4 | Comparative Example A1 | Comparative Example A2 |
|---|---|---|---|---|---|---|---|
| Component (% by mass) | Inorganic filler A1 | 65.00 | 66.25 | | | | |
| | Inorganic filler A2 | 10.00 | 5.00 | 5.00 | 5.00 | | |
| | Inorganic filler A3 | | 5.00 | 5.00 | 5.00 | 5.00 | |
| | Inorganic filler A4 | | | 66.25 | | | |
| | Inorganic filler A5 | | | | 66.25 | | |
| | Inorganic filler A6 | | | | | 71.25 | |
| | Inorganic filler A7 | | | | | | 76.25 |
| | Coloring agent A1 | 0.30 | | | | | |
| | Coupling agent A1 | 0.10 | | | | | |
| | Coupling agent A2 | 0.20 | 0.10 | 0.10 | 0.10 | 0.10 | 0.10 |
| | Coupling agent A3 | | 0.20 | 0.20 | 0.20 | 0.20 | 0.20 |
| | Epoxy resin A1 | 8.99 | | | | | |
| | Epoxy resin A2 | | 8.00 | 8.00 | 8.00 | 8.00 | 8.00 |
| | Curing agent A1 | 3.99 | | | | | |
| | Curing agent A2 | | 4.56 | 4.56 | 4.56 | 4.56 | 4.56 |
| | Curing accelerator A1 | 0.50 | 0.40 | 0.40 | 0.40 | 0.40 | 0.40 |
| | Curing accelerator A2 | 0.07 | 0.04 | 0.04 | 0.04 | 0.04 | 0.04 |
| | Release agent A1 | 0.20 | 0.25 | 0.25 | 0.25 | 0.25 | 0.25 |
| | Additive A1 | 10.00 | 10.00 | 10.00 | 10.00 | 10.00 | 10.00 |
| | Silicone A1 | 0.15 | 0.20 | 0.20 | 0.20 | 0.20 | 0.20 |
| | Low-stress agent A1 | 0.50 | | | | | |
| Total (% by mass) | | 100.00 | 100.00 | 100.00 | 100.00 | 100.00 | 100.00 |
| ((B)+(C)) (% by mass) | | 85.00 | 86.25 | 86.25 | 86.25 | 86.25 | 86.25 |
| Size of inorganic filler | d₁₀ (µm) | 0.60 | 0.05 | 0.90 | 0.90 | 0.41 | 1.30 |
| | d₅₀ (µm) | 3.00 | 3.60 | 8.00 | 8.60 | 21.60 | 2.40 |
| | dₘₐₓ (µm) | 21.00 | 43.00 | 69.00 | 78.00 | 110.00 | 5.00 |
| | Ratio of particles having 1 to 20 µm | 78% | 75% | 89% | 90% | 38% | 96% |
| Production method | Whether to use sieve | Used | Used | Used | Used | Not used | Not used |
| Evaluation result | Angle of fall (°) | 25 | 25 | 28 | 30 | 38 | 40 |
| | Moldability | A | A | A | A | A | D |
| | Plating properties | A | A | A | B | B | A |
| | L/S (µm/µm) | 20/20 | 20/20 | 30/30 | 50/50 | 100/100 | 20/20 |

Based on Table 1, the resin compositions obtained in each of the example had an excellent balance between each effects of moldability, plating properties, and narrowing of L/S pitch, as compared with those obtained in comparative examples.

### (Examples B1 and B2)

Thermosetting resin compositions for LDS of each of the examples were prepared according to formulations shown in Table 2 and evaluated. Components used in each of the examples are as follows.

### (Materials)

### (Inorganic filler)

Inorganic filler B1: Amorphous silica/crystalline silica, MUF-4V, manufactured by TATSUMORI LTD., average particle size 3.8 µm
Inorganic filler B2: Silicon dioxide, SC-2500-SQ, manufactured by Admatechs Company Limited, average particle size 0.6 µm
Inorganic filler B3: Silicon dioxide, SC-5500-SQ, manufactured by Admatechs Company Limited, average particle size 1.6 µm
Inorganic filler B4: Silicon dioxide, TS-6026, manufactured by Micron Co., Ltd., average particle size 9.0 µm

### (Coupling agent)

Coupling agent B1: 3-Glicydoxypropyltrimethoxysilane, S510 manufactured by Chisso Corporation
Coupling agent B2: N-phenyl-γ-aminopropyltrimethoxysilane, CF-4083, manufactured by Dow Corning Toray Co., Ltd.

### (Thermosetting resin)

Epoxy resin B1: Phenol aralkyl-type epoxy resin having a biphenylene skeleton, NC3000, manufactured by Nippon Kayaku Co., Ltd.

### (Curing agent)

Curing agent B1: Phenol aralkyl-type resin having a biphenylene skeleton, MEH-7851SS, manufactured by Meiwa Plastic Industries, Ltd.
(Curing accelerator)
Curing accelerator B1: Tetraphenylphosphonium bis(naphthalene-2,3-dioxy)phenylsilicate
Curing accelerator B2: Tetraphenylphosphonium-4,4'-sulfonyldiphenolate

### (Release agent)

Release agent B1: Glycerin trimontanic acid ester, Licolub WE4 manufactured by Clariant Japan Co., Ltd.
(Additive: non-conductive metal compound)
Additive B1: Inorganic composite oxide, 30C965, manufactured by The Shepherd Color Company

### (Silicone)

Silicone B1: Polyoxyalkylene epoxy-modified dimethylpolysiloxane, FZ-3730, manufactured by Dow Corning Toray Co., Ltd.

### (Preparation of thermosetting resin composition)

The respective raw materials in the formulation amounts shown in Table 2 were mixed at normal temperature using a mixer, and then roll-kneaded at 70°C to 100°C. Subsequently, the obtained kneaded product was cooled, followed by pulverization, to obtain a thermosetting resin composition in a powdery shape. Then, for some of the examples, coarse particles and fine powder were removed using a sieve to obtain a powdery thermosetting resin composition.

### (Measurement of angle of fall and difference angle of thermosetting resin composition)

As shown in (a) of Fig. 3, granular thermosetting resin compositions 502 were put using a funnel 501 from a vertical direction toward the center of a discotic horizontal plate 505 having a diameter of 80 mm and attached to a powder tester (manufactured by Hosokawa Micron Corporation, model type PT-E), and thereby a conical granular body 504 was formed on the horizontal plate 505. The granular thermosetting resin compositions were put until the cone maintained a constant shape, and an angle of elevation (φ) was obtained using a protractor as shown in (a) of Fig. 3 to obtain an angle of repose. Next, as shown in (b) of Fig. 3, a 109-g weight 503 on the same pedestal 506 as the horizontal plate 505 was dropped three times from a height of 160 mm, and a part of the granular thermosetting resin composition was collapsed by the impact and dropped. Thereafter, an angle of elevation (θ) of the granular body 507 was obtained using a protractor as shown in (b) of Fig. 3, and an angle of fall was measured. Then, a difference between the angle of repose and the angle of fall was taken as an angle of difference.

### (Measurement of average particle size d₅₀ of thermosetting resin composition)

A dso of the thermosetting resin composition obtained in each of the examples was measured by a laser diffraction particle size distribution analyzer (manufactured by Shimadzu Corporation, SALD-7000).

### (Measurement of size of inorganic filler)

Particle size distributions and d₅₀ of the all inorganic fillers used in each of the examples were measured by a laser diffraction particle size distribution analyzer (SALD-7000, manufactured by Shimadzu Corporation).

### (Evaluation method)

### (Supply stability of resin composition)

For the resin composition obtained in each of the examples, while testing the resin and reducing a pressure inside a cavity, MapBGA (a BT resin substrate not having a circuit or a via interconnect, PKG outer dimensions: 234 mm × 71 mm × 0.2 mm, no chip mount) was molded using a release film and using a compression molding machine (manufactured by TOWA) in automatic resin supply mode at mold temperature of 175°C and a clamp pressure of 9.6 MPa for an injection (compression) time of 20 seconds and a curing time of 120 seconds. A was given when 10 sheets could be molded continuously, and D was given when molding was interrupted due to an error generated in a resin supply part.

### (Moldability)

Molded products, with 50 mm × 50 mm × thickness 2 µm, of the resin compositions obtained in each of the examples were obtained under the condition of 175°C using a transfer molding machine. A sample of the obtained molded product was observed and evaluated according to the following evaluation standards.
A: Both of internal voids and external voids were not present
C: External voids were observed
D: Unfilled parts were present

### (Plating properties)

The resin compositions obtained in each of the examples were molded and cured under the condition of 175°C to obtain cured products. Surfaces of the obtained cured products were irradiated with YAG laser, and the plating properties in the regions irradiated with laser were evaluated in accordance with the following evaluation standards.
A: The plating surfaces do not have unevenness.
B: More or less unevenness is observed on the plating surfaces, but there is no area having plating missing.
C: Unevenness is observed on the plating surfaces, but there is no area having plating missing.
D: Severe unevenness is observed on the plating surfaces, and there is an area having plating missing.

### (L/S)

In the same manner as the above-described evaluation of plating properties, a molded product was created, a surface of the obtained resin molded product was irradiated with a UV laser, and a circuit having respective line widths was created. The narrowest pitched lines after conduction are listed in Table 2 as the results of each of the examples.

As evaluation levels, 7 levels of L/S = 20, 30, 40, 50, 75, 100, and 200 µm were used.

**Table 2**

| | | Example B1 | Example B2 |
|---|---|---|---|
| Component (% by mass) | Inorganic filler B1 | 66.25 | |
| | Inorganic filler B2 | 5.00 | 5.00 |
| | Inorganic filler B3 | 5.00 | 5.00 |
| | Inorganic filler B4 | | 66.25 |
| | Coupling agent B1 | 0.10 | 0.10 |
| | coupling agent B2 | 0.20 | 0.20 |
| | Epoxy resin B1 | 8.00 | 8.00 |
| | Curing agent B1 | 4.56 | 4.56 |
| | Curing accelerator B1 | 0.40 | 0.40 |
| | Curing accelerator B2 | 0.04 | 0.04 |
| | Release agent B1 | 0.25 | 0.25 |
| | Additive B1 | 10.00 | 10.00 |
| | Silicone B1 | 0.20 | 0.20 |
| Total (% by mass) | | 100.00 | 100.00 |
| d₅₀ of inorganic filler (µm) | | 3.60 | 8.00 |
| Ratio of particles having 1 to 20 µm in inorganic filler (% by volume) | | 75% | 89% |
| Production method | Whether to use sieve | Used | Used |
| Evaluation result | d₅₀ (mm) | 0.40 | 0.40 |
| | Angle of fall (°) | 25 | 25 |
| | Angle of difference (°) | 8 | 8 |
| | Supply stability of resin | A | A |
| | Moldability | A | A |
| | Plating properties | A | A |
| | L/S (µm/µm) | 20/20 | 30/30 |

Based on Table 2, the resin compositions obtained in each of the example had an excellent balance between each effects of supply stability, moldability, plating properties, and narrowing of L/S pitch of the resin composition, as compared with those obtained in comparative examples.

### (Examples C1 to C4)

The thermosetting resin compositions of each of the examples were prepared according to the formulations shown in Table 3, and encapsulating materials were produced using the obtained thermosetting resin compositions and evaluated. Raw material components used in each of the examples are as follows.

### (Materials)

### (Inorganic filler)

Inorganic filler C1: Amorphous silica/crystalline silica, MUF-4V, manufactured by TATSUMORI LTD., average particle size 3.8 µm
Inorganic filler C2: Silicon dioxide, SC-2500-SQ, manufactured by Admatechs Company Limited, average particle size 0.6 µm
Inorganic filler C3: Silicon dioxide, SC-5500-SQ, manufactured by Admatechs Company Limited, average particle size 1.6 µm
Inorganic filler C4: Silicon dioxide, TS-6026, manufactured by Micron Co., Ltd., average particle size 9.0 µm
Inorganic filler C5: Silicon dioxide, TS-6021, manufactured by Micron Co., Ltd., average particle size 10.0 µm

### (Coloring agent)

Coloring agent C1: Carbon black, carbon #5, manufactured by Mitsubishi Chemical Corporation

### (Coupling agent)

Coupling agent C1: 3-Mercaptopropyltrimethoxysilane, S810 manufactured by Chisso Corporation
Coupling agent C2: 3-Glicydoxypropyltrimethoxysilane, S510 manufactured by Chisso Corporation
Coupling agent C3: N-phenyl-γ-aminopropyltrimethoxysilane, CF-4083, manufactured by Dow Corning Toray Co., Ltd.

### (Thermosetting resin)

Epoxy resin C1: Orthocresol novolac-type epoxy resin, EOCN-1020, manufactured by Nippon Kayaku Co., Ltd.

Epoxy resin C2: Phenol aralkyl-type epoxy resin having a biphenylene skeleton, NC3000, manufactured by Nippon Kayaku Co., Ltd.

### (Curing agent)

Curing agent C1: Novolac-type phenol resin, PR-HF-3, manufactured by Sumitomo Bakelite Co., Ltd.

Curing agent C2: Phenol aralkyl-type resin having a biphenylene skeleton, MEH-7851SS, manufactured by Meiwa Plastic Industries, Ltd.

### (Curing accelerator)

Curing accelerator C1: Tetraphenylphosphonium bis(naphthalene-2,3-dioxy)phenylsilicate
Curing accelerator C2: Tetraphenylphosphonium-4,4'-sulfonyldiphenolate

### (Release agent)

Release agent C1: Glycerin trimontanic acid ester, Licolub WE4 manufactured by Clariant Japan Co., Ltd.

### (Additive: non-conductive metal compound)

Additive C1: Inorganic composite oxide, 30C965, manufactured by The Shepherd Color Company

### (Silicone)

Silicone C1: Polyoxyalkylene epoxy-modified dimethylpolysiloxane, FZ-3730, manufactured by Dow Corning Toray Co., Ltd.

### (Low-stress agent)

Low-stress agent C1: Epoxy polybutadiene, JP-200, manufactured by Nippon Soda Co., Ltd.

### (Measurement of size of inorganic filler)

Particle size distributions of the all inorganic fillers used in each of the examples were measured by a laser diffraction particle size distribution analyzer (SALD-7000, manufactured by Shimadzu Corporation).

### (Preparation of thermosetting resin composition)

The respective raw materials in the formulation amounts shown in Table 3 were mixed at normal temperature using a mixer, and then roll-kneaded at 70°C to 100°C. Subsequently, the obtained kneaded product was cooled, followed by pulverization, to obtain a thermosetting resin composition in a powdery shape. Then, for some of the examples, coarse particles and fine powder were removed using a sieve to obtain a powdery thermosetting resin composition.

### (Measurement of angle of fall of thermosetting resin composition)

This measurement was performed by the aforementioned method with reference to (a) of Fig. 3 and (b) of Fig. 3.

### (Production of encapsulating material)

Molded products, with 50 mm × 50 mm × thickness 2 µm, of the resin compositions obtained in each of the examples were obtained under the condition of 175°C using a transfer molding machine.

### (Evaluation)

### (Moldability)

A sample of the molded product of each of the examples obtained from "Production of encapsulating material" was observed and evaluated according to the following evaluation standards.
A: Both of internal voids and external voids were not present
C: External voids were observed
D: Unfilled parts were present

### (Plating properties)

The resin compositions obtained in each of the examples were molded and cured under the condition of 175°C to obtain cured products.

In the example in which the obtained cured product was hydrophilized, after obtaining the cured product and before irradiation with a laser, ultrasonic cleaning (frequency 40 kHz, output 110 W) was performed for 5 minutes while heating to 50°C using dipropylene glycol monomethyl ether as a treatment liquid to rinse the entire surface of the cured product.

Thereafter, surfaces of the obtained cured products were irradiated with YAG laser (wavelength 1,064 nm), and the plating properties in the regions irradiated with laser were evaluated in accordance with the following evaluation standards.
A: The plating surfaces do not have unevenness.
B: More or less unevenness is observed on the plating surfaces, but there is no area having plating missing.
C: Unevenness is observed on the plating surfaces, but there is no area having plating missing.
D: Severe unevenness is observed on the plating surfaces, and there is an area having plating missing.

### (L/S)

For the examples other than the example in which the evaluation result for plating properties was "D," in the same manner as the above-described evaluation of plating properties, a molded product was created, a surface of the obtained resin molded product was irradiated with a UV laser, and a circuit having respective line widths was created. The narrowest pitched lines after conduction are listed in Table 3 as the results of each of the examples.

As evaluation levels, 7 levels of L/S = 20, 30, 40, 50, 75, 100, and 200 µm were used.

**Table 3**

| | | Example C1 | Example C2 | Example C3 | Example C4 |
|---|---|---|---|---|---|
| Component (% by mass) | Inorganic filler C1 | 65.00 | 66.25 | | |
| | Inorganic filler C2 | 10.00 | 5.00 | 5.00 | 5.00 |
| | Inorganic filler C3 | | 5.00 | 5.00 | 5.00 |
| | Inorganic filler C4 | | | 66.25 | |
| | Inorganic filler C5 | | | | 66.25 |
| | Coloring agent C1 | 0.30 | | | |
| | Coupling agent C1 | 0.10 | | | |
| | Coupling agent C2 | 0.20 | 0.10 | 0.10 | 0.10 |
| | Coupling agent C3 | | 0.20 | 0.20 | 0.20 |
| | Epoxy resin C1 | 8.99 | | | |
| | Epoxy resin C2 | | 8.00 | 8.00 | 8.00 |
| | Curing agent C1 | 3.99 | | | |
| | Curing agent C2 | | 4.56 | 4.56 | 4.56 |
| | Curing accelerator C1 | 0.50 | 0.40 | 0.40 | 0.40 |
| | Curing accelerator C2 | 0.07 | 0.04 | 0.04 | 0.04 |
| | Release agent C1 | 0.20 | 0.25 | 0.25 | 0.25 |
| | Additive C1 | 10.00 | 10.00 | 10.00 | 10.00 |
| | Silicone C1 | 0.15 | 0.20 | 0.20 | 0.20 |
| | Low-stress agent C1 | 0.50 | | | |
| Total (% by mass) | | 100.00 | 100.00 | 100.00 | 100.00 |
| Production method | Whether to use sieve | Used | Used | Used | Used |
| Angle of fall of resin composition (°) | | 25 | 25 | 28 | 30 |
| Ratio of particles having 1 to 20 µm in inorganic filler (% by volume) | | 78% | 78% | 75% | 89% |
| Hydrophilization (ultrasonic cleaning for 5 minutes while heating at 50°C) | | Performed | Performed | Performed | Performed |
| Evaluation result | Moldability | A | A | A | A |
| | Plating properties | A | A | A | B |
| | L/S (µm/µm) | 20/20 | 20/20 | 30/30 | 50/50 |

Based on Table 3, the resin compositions obtained in each of the example had an excellent balance between each effects of moldability, plating properties, and narrowing of L/S pitch, as compared with those obtained in comparative examples.

Hereinafter, an example of a reference aspect will be additionally described.
A1. A thermosetting resin composition for laser direct structuring (LDS) which is used for LDS, the thermosetting resin composition for LDS including the following components:
   (A) a thermosetting resin;
   (B) an inorganic filler;
   (C) a non-conductive metal compound that forms a metal nucleus upon irradiation with active energy rays; and
   (D) a coupling agent, and
      in which the component (A) contains one or more selected from the group consisting of an epoxy resin and a bismaleimide resin, and
      a ratio of particles having a particle size equal to or more than 1 µm and equal to or less than 20 µm in the component (B) is equal to or more than 40% by volume and equal to or less than 95% by volume with respect to a total volume of the component (B).
A2. The thermosetting resin composition for LDS according to A1., in which a particle size d₁₀ of the component (B) is equal to or more than 0.05 µm and equal to or less than 3 µm.
A3. The thermosetting resin composition for LDS according to A1. or A2., further including the following component: (E) a curing accelerator.
A4. The thermosetting resin composition for LDS according to any one of A1. to A3., in which the component (B) contains silica.
A5. The thermosetting resin composition for LDS according to any one of A1. to A4., in which a total content of the component (B) and the component (C) in the thermosetting resin composition for LDS is equal to or more than 70% by mass and equal to or less than 98% by mass with respect to a total mass of the thermosetting resin composition for LDS.
B1. A granular thermosetting resin composition for laser direct structuring (LDS) which is used for LDS, the thermosetting resin composition for LDS including:
   a thermosetting resin;
   an inorganic filler;
   a non-conductive metal compound that forms a metal nucleus upon irradiation with active energy rays; and
   a coupling agent,
   in which the thermosetting resin contains one or more selected from the group consisting of an epoxy resin and a bismaleimide resin, and
   an angle of fall of the thermosetting resin composition for LDS is equal to or less than 35°.
B2. The thermosetting resin composition for LDS according to B1., in which an angle of difference of the thermosetting resin composition for LDS is equal to or more than 5°.
B3. The thermosetting resin composition for LDS according to B1. or B2., in which an average particle size d₅₀ of the thermosetting resin composition for LDS is equal to or less than 1.0 mm.
B4. The thermosetting resin composition for LDS according to any one of B1. to B3., in which an average particle size d₅₀ of the inorganic filler is equal to or less than 10 µm.
B5. The thermosetting resin composition for LDS according to any one of B1. to B4., in which a total content of the inorganic filler and the non-conductive metal compound in the thermosetting resin composition for LDS is equal to or more than 80% by mass and equal to or less than 98% by mass with respect to a total mass of the thermosetting resin composition for LDS.
C1. A method for manufacturing a semiconductor device, the method including:
   encapsulating a semiconductor element, such that a surface of the semiconductor element is covered, with a cured product of a thermosetting resin composition for laser direct structuring (LDS) to form an encapsulating material;
   irradiating a specific portion on a surface of the encapsulating material with active energy rays;
   hydrophilizing the surface of the encapsulating material; and
   selectively forming a metal layer in a region, which is irradiated with the active energy rays, on the surface of the encapsulating material,
   in which the thermosetting resin composition for LDS contains:
      (A) a thermosetting resin;
      (B) an inorganic filler;
      (C) a non-conductive metal compound that forms a metal nucleus upon irradiation with active energy rays; and
      (D) a coupling agent, and
   the component (A) contains one or more selected from the group consisting of an epoxy resin and a bismaleimide resin.
C2. The method for manufacturing a semiconductor device according to C1., in which the hydrophilizing the surface of the encapsulating material is hydrophilizing the specific portion on the surface of the encapsulating material after the irradiating the specific portion with active energy rays.
C3. The method for manufacturing a semiconductor device according to C1. or C2., in which the hydrophilizing includes applying a treatment liquid containing a glycol-based organic solvent to the surface of the encapsulating material.
C4. The method for manufacturing a semiconductor device according to any one of C1. to C3., in which the selectively forming the metal layer includes: applying a metal to the region, and growing a plated layer formed from the metal in the region.
C5. The method for manufacturing a semiconductor device according to any one of C1. to C4., in which a wavelength of the active energy rays is equal to or more than 240 nm and equal to or less than 1,100 nm.

This application claims priority on the basis of Japanese Patent Application No. 2018-236604 filed December 18, 2018, Japanese Patent Application No. 2019-025899 filed February 15, 2019, and Japanese Patent Application No. 2019-025900 filed February 15, 2019, and all of their disclosures are incorporated herein by reference.

## Claims

1. A thermosetting resin composition for laser direct structuring (LDS) which is used for LDS, the thermosetting resin composition for LDS comprising the following components:
(A) a thermosetting resin;
(B) an inorganic filler;
(C) a non-conductive metal compound that forms a metal nucleus upon irradiation with active energy rays; and
(D) a coupling agent,
wherein the component (A) contains one or more selected from the group consisting of an epoxy resin and a bismaleimide resin, and
at least one of the following condition 1 or condition 2 is satisfied:
(condition 1) a ratio of particles having a particle size equal to or more than 1 µm and equal to or less than 20 µm in the component (B) is equal to or more than 40% by volume and equal to or less than 95% by volume with respect to a total volume of the component (B), and
(condition 2) the thermosetting resin composition for LDS is granular, and an angle of fall of the thermosetting resin composition for LDS is equal to or less than 35°.

2. The thermosetting resin composition for LDS according to claim 1,
wherein the thermosetting resin composition for LDS satisfies the condition 1.

3. The thermosetting resin composition for LDS according to claim 2,
wherein a particle size d₁₀ of the component (B) is equal to or more than 0.05 µm and equal to or less than 3 µm.

4. The thermosetting resin composition for LDS according to claim 2 or 3, further comprising the following component:
(E) a curing accelerator.

5. The thermosetting resin composition for LDS according to any one of claims 2 to 4,
wherein the component (B) contains silica.

6. The thermosetting resin composition for LDS according to any one of claims 2 to 5,
wherein a total content of the component (B) and the component (C) in the thermosetting resin composition for LDS is equal to or more than 70% by mass and equal to or less than 98% by mass with respect to a total mass of the thermosetting resin composition for LDS.

7. The thermosetting resin composition for LDS according to claim 1,
wherein the thermosetting resin composition for LDS satisfies the condition 2.

8. The thermosetting resin composition for LDS according to claim 7,
wherein an angle of difference of the thermosetting resin composition for LDS is equal to or more than 5°.

9. The thermosetting resin composition for LDS according to claim 7 or 8,
wherein an average particle size d₅₀ of the thermosetting resin composition for LDS is equal to or less than 1.0 mm.

10. The thermosetting resin composition for LDS according to any one of claims 7 to 9,
wherein an average particle size d₅₀ of the component (B) is equal to or less than 10 µm.

11. The thermosetting resin composition for LDS according to any one of claims 7 to 10,
wherein a total content of the component (B) and the component (C) in the thermosetting resin composition for LDS is equal to or more than 80% by mass and equal to or less than 98% by mass with respect to a total mass of the thermosetting resin composition for LDS.

12. A method for manufacturing a semiconductor device, the method comprising:
encapsulating a semiconductor element, such that a surface of the semiconductor element is covered, with a cured product of a thermosetting resin composition for laser direct structuring (LDS) to form an encapsulating material;
irradiating a specific portion on a surface of the encapsulating material with active energy rays;
hydrophilizing the surface of the encapsulating material; and
selectively forming a metal layer in a region, which is irradiated with the active energy rays, on the surface of the encapsulating material,
wherein the thermosetting resin composition for LDS is the thermosetting resin composition for LDS according to any one of claims 1 to 11.

13. A method for manufacturing a semiconductor device, the method comprising:
encapsulating a semiconductor element, such that a surface of the semiconductor element is covered, with a cured product of a thermosetting resin composition for laser direct structuring (LDS) to form an encapsulating material;
irradiating a specific portion on a surface of the encapsulating material with active energy rays;
hydrophilizing the surface of the encapsulating material; and
selectively forming a metal layer in a region, which is irradiated with the active energy rays, on the surface of the encapsulating material,
wherein the thermosetting resin composition for LDS includes the following components:
(A) a thermosetting resin,
(B) an inorganic filler,
(C) a non-conductive metal compound that forms a metal nucleus upon irradiation with active energy rays, and
(D) a coupling agent, and
the component (A) contains one or more selected from the group consisting of an epoxy resin and a bismaleimide resin.

14. The method for manufacturing a semiconductor device according to claim 12 or 13,
wherein the hydrophilizing the surface of the encapsulating material is hydrophilizing the specific portion on the surface of the encapsulating material after the irradiating the specific portion with active energy rays.

15. The method for manufacturing a semiconductor device according to any one of claims 12 to 14,
wherein the hydrophilizing includes:
applying a treatment liquid containing a glycol-based organic solvent to the surface of the encapsulating material.

16. The method for manufacturing a semiconductor device according to any one of claims 12 to 15,
wherein the selectively forming the metal layer includes:
applying a metal to the region, and
growing a plated layer formed from the metal in the region.

17. The method for manufacturing a semiconductor device according to any one of claims 12 to 16,
wherein a wavelength of the active energy rays is equal to or more than 240 nm and equal to or less than 1,100 nm.
